(19) Europäisches Patentamt / European Patent Office / Office européen des brevets

(11) EP 1 131 847 B1

(12) **EUROPEAN PATENT SPECIFICATION**

(45) Date of publication and mention of the grant of the patent: **17.02.2010 Bulletin 2010/07**

(21) Application number: **99954133.7**

(22) Date of filing: **03.11.1999**

(51) Int Cl.: ***H01L 21/3213*** *(2006.01)*

(86) International application number: **PCT/GB1999/003630**

(87) International publication number: **WO 2000/026956 (11.05.2000 Gazette 2000/19)**

# (54) A METHOD FOR ETCHING A SUBSTRATE

VERFAHREN ZUR ÄTZUNG EINES SUBSTRATS

PROCEDE ET DE GRAVURE DE SUBSTRAT

(84) Designated Contracting States: **AT BE CH CY DE DK ES FI FR GB GR IE IT LI LU MC NL PT SE**

(30) Priority: **04.11.1998 GB 9824077**
**29.01.1999 GB 9901867**
**28.05.1999 GB 9912376**

(43) Date of publication of application: **12.09.2001 Bulletin 2001/37**

(73) Proprietor: **SURFACE TECHNOLOGY SYSTEMS PLC**
**Newport**
**Gwent NP10 8UJ (GB)**

(72) Inventors:
- **BHARDWAJ, Jyoti, Kiron**
  **Bristol BS12 0BH (GB)**
- **ASHRAF, Huma**
  **Newport NP9 4LT (GB)**
- **HOPKINS, Janet**
  **Crickhowell,**
  **Powys NP8 1BP (GB)**
- **LEA, Leslie, Michael**
  **Didcot,**
  **Oxfordshire OX11 9JH (GB)**
- **HYNES, Alan, Michael**
  **Cardiff CF1 9LL (GB)**
- **JOHNSTON, Ian, Ronald**
  **St. Mellons,**
  **Cardiff CF3 0RA (GB)**

(74) Representative: **Lambert, Ian Robert et al**
**Wynne-Jones, Lainé & James LLP**
**Essex Place**
**22 Rodney Road**
**Cheltenham**
**Gloucestershire GL50 1JJ (GB)**

(56) References cited:
**EP-A- 0 363 982** **EP-A- 0 710 977**
**EP-A- 0 822 582**

- **KURE T, GOTOH Y, KAWAKAMI H, TACHI S: "Highly Anisotropic Microwave Plasma Etching for High Packing Density Silicon Patterns" 1992, NEW YORK, NY, USA, IEEE, USA, pages 48-49, XP000874303**
- **PATENT ABSTRACTS OF JAPAN vol. 1998, no. 08, 30 June 1998 (1998-06-30) -& JP 10 074730 A (HITACHI LTD), 17 March 1998 (1998-03-17)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 131 847 B1

## Description

This invention relates to a method for plasma etching a feature in a substrate, for example a semiconductor substrate, in particular to a method of reducing or eliminating localised etching of the substrate ("notching") or charge damage at the interface with an insulating underlayer, or localised etching of the sidewall of a trench in the substrate.

When etching silicon (or any other material), which becomes isolated by an insulating underlayer (such as silicon dioxide), the silicon accumulates charge as a result of the current drawn from the plasma during the process. This volume charge is proportional to the current, the surface area and the thickness of silicon above the oxide layer. The other factor which needs to be considered is that of the surface charge component on the silicon and the oxide. As this charge increases, it can have a proportionately increasing influence on the ion trajectory angle, which in turn influences the silicon etch profile, particularly at the silicon to oxide interface. The net result of excessive ion charging is localised etching of the silicon or "notching" at the oxide interface. It has been found that, if the oxide (or other dielectric) layer is replaced by a conducting layer, then the "notching" is not observed.

In some applications, this notching is highly undesirable, either due to causing problems in post processing steps (such as the re-fill of silicon isolation trenches), or due to the impact of the profile deterioration on the device performance.

A number of solutions to this problem have been proposed. Most are based on methods of either "neutralising" the accumulated surface charge, or reducing the ion charging of the silicon directly. For example, Toshihisa Nozawa et al (1994 Dry Process Symposium, Tokyo, I-8, p37ff) refers to the reduction of ion charging by operating at relatively higher pressures so that an increase in the negative ion concentration results in "neutralisation" of the accumulated surface charge. Whilst this method has been used with some success, operating at these pressures does cause some restrictions with respect to the etched profile such that it is not a suitable application for the entire etch. Indeed, the approach of using relatively higher pressures can only be used as a second etch step to approach the silicon interface, before the silicon begins to etch clear of the oxide interface.

Morioka et al, J. Vac. Sci. Technol. A 16(3), May/Jun 1998, pp 1588-1593 discloses the use of lower frequency to reduce notching and charge damage.

Kinoshita et al "Simulation of Topography Dependent Charging with Pulse Modulated Plasma", Proc.Sym. On Dry Process, Vol.18, I-6, pp 37-42, 1996 discloses source pulsing using continuous wave (CW) bias to achieve notch and charge damage reduction or elimination.

The theory of source pulsing reducing notching relates to the bias reduction as a result of the after-glow plasma during the off state, see Kinoshita et al. This approach works very well for low pressure HDP processing and as such it has inherent limitations. The major drawback is that the method only works when the plasma completely extinguishes. The plasma essentially comprises two excitation components, the first results from the source (ICP,ECR etc) and the second results from the RF bias. These two components control the plasma density and self bias potential for ion acceleration respectively. When the source power is reduced, the self bias increases proportionately. Thus, when the source power is off, extremely high self bias voltages are obtained until or unless the plasma extinguishes. If the plasma does extinguish (which is certainly valid for low pressure and low bias power operation, cited in the prior art references including Kinoshita), source pulsing is an effective solution. However, for relatively higher pressure plasmas (approaching or greater than 10mTorr), the plasma does not extinguish, even at low bias RF power levels. In such cases the source pulsing method is not suitable.

During source power switching with CW RF bias, for the reasons explained above, as the source power switches off, high self bias transient voltages are inevitable. These transients may lead to charge damage. As the source power levels increase (to enhance the etching rate), this effect will increase and potentially cause unacceptable charge damage and possibly even increased notching.

Maruyama et al, "Reduction in charge build-up with pulse-modulated bias in pulsed ECR plasma", IEE Proc. Dry Process Sym. Japan, I-4 pp 21-26, 1997 discloses the use of a pulsed bias at 13.56 MHz (high frequency), but reports a residual notch size of at least 70nm in the best case.

A similar problem to "notching" is the "breaking effect" which is localised etching of the sidewall and is due to a potential gradient across the electrode and a localised negative charging of a masking layer on the substrate.

The method of this invention, in at least some embodiments, addresses or reduces these various problems.

European Patent Application EP0363982 discloses a dry etching technique in which steps of etching and applying a passivation layer are performed alternatively, and in which a high frequency RF bias power is applied to a substrate. JP 10 074730 discloses an etching process which utilises a plasma power source that operates in a specific frequency range and is modulated by a bias power source. Kure et al ("Highly Anisotropic Microwave Plasma Etching for High Packing Density Silicon Patterns", 1992, New York, NY, USA IEEE USA, pp48-49) discloses plasma etching of silicon wafers in which a pulsed RF bias can be applied to the wafer. European Patent Application No. EP0710977 discloses an etching system in which a pulsed voltage having a duty ratio of 5% or below and a repetition frequency of 400 KHz or above is utilised in order to suppress notching or charge build-up damage. European Patent Application EP0822582 discloses an etching technique in which alternate etching and passivation layer deposition steps are utilised, and various process parameters are varied in order to optimise the etch.

According to a first aspect of the present invention, there is provided a method of etching a feature in a substrate in a chamber in which the substrate comprises an insulating underlayer, the method comprising alternately etching a semiconductor or conductor by means of a plasma and depositing a passivation layer by means of a plasma, wherein, during the etching step, a bias voltage is applied to the substrate, in which the bias voltage is not pulsed and has a frequency which is at or below the ion plasma frequency so as to reduce or eliminate localised etching of the substrate or charge damage at the interface of the semiconductor or conductor with the insulating underlayer, **characterised in that** the method further comprises: a further etching and passivation step which is carried out after the alternate etching and deposition step and at a higher pressure than the alternate etching and deposition step; and an end-point detection step to determine when to switch from the alternate etching and deposition first step to the further etching and passivation step.

According to a second aspect of the present invention, there is provided a method of etching a feature in a substrate in a chamber in which the substrate comprises an insulating underlayer, the method comprising alternately etching by means of a plasma and depositing a passivation layer by means of a plasma, **characterised in that** during the etching step a pulsed RF bias voltage having an RF bias frequency is applied to the substrate.

In this aspect of the invention a high or low bias voltage may be applied.

The ion plasma frequency is represented by $\omega_{p1.}$

The bias voltage may be produced by an RF bias power supply, and is preferably applied to a support or platen on which the substrate may be positioned. A dc bias, which may be pulsed, may be used in conjunction with pulsed RF bias.

The substrate is preferably a semiconductor, for example silicon. In a particular embodiment, the substrate includes an insulating underlayer. This underlayer may be an oxide. In the embodiment in which silicon is used as the semiconductor, silicon dioxide is the underlayer. However, for example, the invention also relates to etching polysilicon and other conductors (eg $Wsi_2$ or indeed other metal silicides) over gate oxide. Alternatives are well known to a person skilled in the art. The substrate may have a masking layer on its upper surface, which may be an insulator.

By using a low bias frequency, and/or a pulsed voltage reduced "notching", "beaking effect", or charge damage may be achieved. In a preferred embodiment, the bias frequency is at or below 4 MHz, and even more preferably is in the range of 50 kHz to 380 kHz.

The first aspect of the invention comprises a further etching and passivating step (step 2) which is carried out at a higher pressure than the etching or alternate etching and deposition step. This further step may or may not be alternately cyclic. In particular, this further step which is carried out at a higher pressure is started when the underlayer is approached, for example in one embodiment either just before or any time up to just after the silicon begins to etch clear from the oxide interface.

For example, when etching thick silicon (>several microns) on the insulator then step 1 is used until critical features have approximately 0.5μm of silicon remaining to be etched, at the substrate edge. The edges etch faster than the substrate centre. At the centre there is approximately 1μm of silicon remaining to be etched. Step 2 is then used until the oxide is reached at all points of the substrate and a sufficient over etch may be used to ensure this.

This further etching and passivation step provides a reduction in the rate of increase in the notch size as a function of over-etch time. Preferably, in this embodiment, the method further comprises an end-point detection step to determine when to switch from the etching or alternate etching and deposition first step to the further etching and passivation step.

However, when the bias voltage is pulsed, the further etching and passivation step at a higher pressure is not necessary and therefore the process window is much wider, allowing higher mean etching rates as well as avoiding profile deterioration. Furthermore, in this embodiment end point detection is not necessary and a greatly improved notch width control over a much wider range of feature sizes is achieved. Indeed, the notching may be eliminated using this method.

We define the duty cycle as the ratio of pulse on time (or pulse width) to pulse off time. The pulse width and duty cycle that is ideally required depends on the bias frequency and the RC time constant associated with the charge build up on the oxide interface. It should be noted that it is more attractive commercially to pulse lower power supplies that are used for biasing rather than significantly higher power source supplies, as in the prior art.

It is the pulse off duration which determines the degree of discharging.

The pulse off time is preferably greater than 100μs. The pulse off time is preferably applied for between 10% to 90% of the time (ie. 10% to 90% duty cycle). Preferably, the duty cycle is controlled in proportion to the pulse off time. A shorter pulse off time will allow a greater duty cycle and vice versa.

A magnetic filter as described in British patent application 9827196.8 may be used to partially or completely divide the volume of the chamber in which the plasma is formed, from the volume in which the wafer or workpiece support is located. The filter has the effect of reducing the plasma density, but also reduced the electron temperature, making conditions favourable for increased numbers of negative ions to reach the vicinity of the wafer. When used in conjunction with a sufficiently low frequency bias on the wafer support, positive ions will be accelerated towards the wafer during the more negative part of the cycle. Negative ions and electrons will be accelerated towards the wafer during the more positive part of the cycle. A superimposed negative self bias will form unless the fraction of electrons is extremely small. The flux of negative ions reaching the wafer during the relevant part of the cycle, will etch material in a similar way to positive ions, but will also act to reduce charging produced by the positive ions. Pulsing of the bias may be utilised if required.

Although the invention has been defined above, it is to be understood that it includes any inventive combination of the features set out above or in the following description.

The invention may be performed in various ways and a specific embodiment will now be described by way of example, with reference to the accompanying drawings, and in which:

Figures 1A and 1B are schematic cross-section views explaining notching;
Figures 2A and 2B show scanning electron micrographs (SEMs) showing the etching of a prior art process;
Figure 3 shows a further SEM of the prior art in which grass formation results;
Figures 4A to C show SEMs achieved from the present invention;
Figure 5 is a graph showing the rate of increase in notch size as a function of over-etch time;
Figures 6A and B show SEMs achieved by the process of the present invention;
Figures 7 to 10 are graphs showing the variation of various parameters with duty cycle;
Figures 11 and 12 show alternative circuits for use in the present invention,
Figure 13 shows details of bias options,
Figure 14 shows a graph of charge and potential versus time,
Figures 15 and 16 show typical effects on etching an insulating substrate,
Figure 17 shows the result of pulsing rf bias in etching an insulating substrate;
Figure 18 shows a SEM illustrating the "beaking effect",
Figure 19 shows a SEM achieved from the present invention; and
Figures 20(a) to (c) show SEMs demonstrating control of RIE lag; and
Figures 21(a) to (d) show SEMs demonstrating results obtained using low frequency pulsed biasing.

Referring to Figures 1A and 1B, there is shown a substrate generally at 1. The substrate 1 comprises a silicon semiconductor 2 with a silicon dioxide underlayer 3. On the upper surface of semiconductor 2 is a masking layer 4. On etching a substrate in a plasma, for example by the method disclosed in WO-A-94/14187, a trench 5 is formed. Ions are shown at 6 and electrons are shown at 7.

The present invention seeks to reduce or eliminate notching.

When RF bias is applied to the Platen, the ions will be accelerated towards the wafer/workpiece throughout most of the RF cycle. The electrons which must reach the wafer to balance the ion flux, will only reach the wafer during the most positive part of the RF cycle.

For high frequencies $>\omega_{pi}$, the ions are not able to respond to the instantaneous electric potential and are accelerated by the time averaged potential which is of order Vpp/2. The ions which reach the wafer will generally have an energy distribution function which is relatively narrow and centered around Vpp/2.

For low frequencies $<\omega_{pi}$, the ions can to some extent respond to the instantaneous RF potential, progressively more so as the frequency is reduced. The ion energy distribution function will therefore become progressively wider as the frequency is dropped with energy extending towards the limits of at maximum Vpp and at minimum near to zero, centered close to Vpp/2.

At the high frequencies the ion energy distribution has a relatively higher number of high energy ions which allows most of these ions to reach the bottom of deep trenches. Etching takes place down to any insulating layer, which can then charge positive, leading to deflection of further ions to cause notching. This build up of high positive potential is limited by the electrons, which become increasingly attracted as the charge accumulates. The major impact of the electrons is to negatively charge the top surface (particularly the edge) of the trenches due to their isotropic directionality. This acts as a "potential barrier" effectively reducing the number of electrons which will pass further into the trench as this surface charge increases. The ions conversely have a narrow angular spread and increased directionality. As the aspect ratio increases, the electrons are increasingly shielded from the accumulated positive charge at the bottom of the trench as the net electric field effect from this charge decreases.

Low energy ions have lower directionality, or in other words increased directional isotropy. This makes these ions more able to provide surface electron charge neutralization. At the low frequencies, the ion energy distribution function broadens and increases the number of lower energy ions. This allows some neutralization of the negative charge at the top of the trenches, which then reduces the "potential barrier" a bit further and permits further electrons to reach the bottom of the trench and reduce the positive charge which builds up on an insulating layer. This reduces the potential at the bottom of the trench and also reduces the degree of notching.

If the RF bias applied to the Platen is pulsed on and off, during the off periods the ion sheath will relax to the steady dc situation in which the wafer reaches conventional plasma floating potential. All ions are accelerated to a much lower energy when compared with the result of RF bias, and have a larger angular distribution. This further increases the ability to reduce the negative charge near the top of the trenches and to a further reduction in the positive charging of an insulating layer at the bottom of the trenches. The result is reduced notching as shown in Figure 1B. The positive potential at the bottom of the trench is also further reduced due to the easier access of electrons to the insulating surface as the potential barrier is reduced further. During the RF off period the low energy of the positive ions is insufficient to remove the passivating layer at the bottom of the trenches, and this is only removed by the higher energy ions when the RF is switched back on.

It can therefore be seen that a reduction in notching and the reduction of high potentials at the insulating surface can be achieved by decreasing the Platen RF bias frequency and further reductions are achieved by pulsing the RF bias on and off. The RF bias off time here must exceed an RC time constant which represents the oxide surface charging and this is estimated as being of the order of several milli-seconds for low frequency (380kHz) and several hundreds of micro-seconds for high frequency (13.56MHz).

To summarise, Figure 1A shows:

1. Accelerated ions are directional, electrons are isotropic.
2. Directional ions ⊕ reach trench base and cause charge build up on the oxide, resulting in the potential V+.
3. Directionally isotropic electrons charge surface of trench, and only a few reach the base to neutralize the ion charge.
4. Ion charge potential V+ on the oxide is determined by the ion energy distribution function (IEDF), refer to Kinoshita et al.
5. Ions ⊕ with an energy >V+ contribute to increasing V+.
6. Ions ⊕ (shaded) with an energy <V+ are deflected towards the sidewall by V+ and contribute to notching. Figure 1B shows:

    1. IEDF changes to result in greater number of lower energy ions ⊕ (shaded).
    2. These ions ⊕ (shaded) have greater directional isotropy and reduced mean ion energy.
    3. This results in reduced electron charging of the top of the trenches, and increases the number of electrons e-which reach the bottom of the trench and neutralize the charge.
    4. The ions reaching the bottom of the trench have reduced energy, but they still have directionality. When the RF bias is in the off state, ions will gain energy corresponding to the potential difference between the plasma and floating potential.
    5. These effects will reduce the charge potential V+.
    6. This charge may be lower than the threshold for damage to the oxide.
    7. Lower energy ions are deflected by V+ into the side walls with an increased angular distribution.
    8. These ions do not have sufficient energy to cause notching.

It should be noted that conventional non-switched plasma etching means may also be applied and these are well known to those skilled in the art.

During a pulse cycle, the charge and potential on the insulating layer at the bottom of a trench will follow the trend shown by the solid line in Figure 14. RF bias is applied to the platen during the period from t=o to t=$t_1$. Positive charge increases on the bottom of the trench as does the positive potential to attract some electrons. Saturation of charge and potential is reached, as shown by the dashed line, when the potential has reached a level which prevents further positive ions from reaching the bottom of the trench. At time $t_1$, the RF bias is switched off, low energy positive ions with large angular spread start to neutralise the negative charge near the top of the trench, allowing more electrons to reach the bottom of the trench. The positive charge at the bottom of the trench reduces steadily and the potential reduces, until electron and positive ion fluxes come to a balance.

It is generally desirable to reduce the RF bias gate pulse length from that shown in Figure 14, in order to reduce the magnitudes of charge and potential built up at the bottom of the trench, before discharging takes place.

Referring to Figure 2, there is shown a SEM in Figure 2A showing the notching of the silicon at the oxide interface as discussed above in relation to the prior art. These are the results obtained using cyclic etch/passivation (referred to as step 1) only with a 13.56 MHz bias frequency. Figure 2B shows the profile without notching obtained by using the two step (step 1 and step 2) process, the step 2 process being carried out at a higher pressure and higher passivation level as discussed above. A 13.56 MHz bias frequency was used. The trench etch in step 1 is etched using the method disclosed in WO-A-94/14187 (cyclic etch/passivation). Step 2 may or may not be switched in the same manner. In this case this was also switched, but at higher pressure and with a higher passivation content to reduce the notching, alternative process conditions may be:

Step 1

Etch Step:

130 sccm $SF_6$ (8s cycle on time), 600 Watts Coil Power (13.56 MHz), 8-12W Platen Power (13.56 MHz), 20mT pressure, 20 degrees centigrade platen temperature.

Passivation Step:

100 sccm $C_4F_8$ (5s cycle on time), 600 Watts Coil Power (13.56MHz), 0W Platen Power (13.56MHz), 17mT pressure, 20 degrees centigrade platen temperature.

Step 2

Etch step:

100sccm $SF_6$ + 60 sccm $C_4F_8$ (12s cycle on-time), 600-800W Coil Power (13.56MHz), 12-17 W Platen Power (13.56MHz), 65-75mT pressure, 20 degrees centigrade platen temperature

Passivation Step:

120 sccm $C_4F_8$ (5s cycle on-time) 600 Watts Coil Power (13.56MHz), 0W Platen Power (13.56MHz), 55mT pressure, 20 degrees centigrade platen temperature.

This step 2 is suitable to etch depths typically up to several microns. The SEM in figure 3 shows the result of using step 2 for etch depths greater than this, demonstrating the limitation of this second step. Typically the second step differs from the first in that the etch rate is reduced (by a factor of 3 or 4) and also as the depth increases, grass formation results in the termination of the etch. Thus, the first step has relatively high etch rate which is not depth limited due to residue or grass formation. Both effects are the result of the enhanced passivation in the second step, which is necessary along with the higher pressure in order to reduce the notching. Therefore, the first step is balanced in favour of etching over deposition (without any net deposition build up), while the second step balance exhibits a net deposition build up. As the first step aggressively notches, it is important to adequately terminate this step and switch to the second step before notching can occur. This transition is typically detected by means of an endpoint detection system, which can be used either to detect the instant the oxide underlayer is reached or detect the remaining silicon thickness when approaching the interface. It is essential to use this endpoint method in the known processes to facilitate the first to second step transition to ensure wafer to wafer repeatability, particularly when the initial silicon thickness on top of the oxide can vary.

The second step also has to allow over-etching. Over-etch is defined as the additional etching time after the first area of oxide becomes exposed (by etching the silicon clear) in any part of the substrate (wafer). As the etch rate varies across the substrate usually radially, some areas will have interface exposure prior to others. This implies that in order to clear the silicon from all areas of the substrate, some over-etching is necessary. In addition, other well known effects such as (Reactive Ion Etching) "RIE Lag" and "Microloading" mean that the etch rate can further vary with feature size and across areas of the substrate wafer with differing ratios of mask to silicon exposure. This places a greater emphasis on the need to over-etch and maintain the etched profile during it.

The present invention in one embodiment eliminates the notching by significantly reducing the ion charging of the silicon oxide using a pulsed low frequency rf bias power supply.

In known processes, the rf bias is applied in the few MHz to 40MHz range, typically at 13.56 MHz. However, it has been found that this frequency is above the ion plasma frequency, so that the ions do not respond to the rf field. Instead they respond only to the dc self bias potential. The electrons due to their small size and mass have much higher mobility and respond to the rf excitation.

In one example of the present invention, bias frequencies of 380kHz and 187kHz are used. The SEMs in Figure 4 show the best result obtained at silicon/oxide interface after using either lower excitation frequency.

Low frequency only (unpulsed) process conditions may be:

Step 1

Etch step:

100 sccm $SF_6$ (5s cycle on time), 600W Coil Power (13.56 MHz), 4-8W Platen Power (380kHz), 20mT Pressure, 20 degrees centigrade platen temperature.

Passivation step:

130 sccm $C_4F_8$ (5s cycle on time), 600W Coil Power (13.56 MHz), 0W Platen Power (380 kHz), about 22mT Pressure, 20 degrees centigrade platen temperature.
A total of 8 minutes process time for step 1.

Step 2

Etch step:

100 sccm $SF_6$ + 60 sccm $C_4F_8$ (10 s cycle on time), 800W Coil Power (13.56 MHz), 6-8W Platen Power (380 kHz), about 60-75mT Pressure, 20 degrees centigrade platen temperature.

Passivation step:

130 sccm $C_4F_8$ (5s cycle on time), 800W Coil Power (13.56 MHz), 0W Platen Power, about 45mT Pressure, 20 degrees centigrade platen temperature.
Figure 4A shows the results using a low frequency bias in step 1 only. Figure 4B shows the results using a low frequency bias in both step 1 and step 2. Figure 4C shows a close up of the trench base at the silicon-oxide interface. Even at lower frequencies, it was found to be necessary to use a high pressure process with a higher passivation content to achieve the zero notch result shown in Figure 4B. Again, this higher pressure process/higher passivation step could not be used for the entire etch depth as surface residues or "grass" appears when etch depths of about 5μm are exceeded. As with the high frequency bias of the prior art, etch rates for this second step are lower and in addition prolonged second step processing directly leads to profile bowing. Nevertheless, there is still an advantage with the lower frequency biasing of the invention. This can be summarised as a reduction in the rate of increase in notch size as a function of over-etch time, as shown in Figure 5. This benefit allows better control of the notch size compared to higher frequencies.
End-point detection will still be required for determining the step 1 to step 2 transition time.
The ion plasma frequency is given by:

$$\omega_{pi} = (n_i Z^2 e^2 / \epsilon_0 m_i)^{1/2}$$

where $n_i$, $m_i$, are ion density and mass, Z is ionic charge number, e is elementary charge and $\epsilon_0$ is permittivity constant of vacuum.
The etching step is typically carried out using a high fluorine liberating gas such as $SF_6$ or $NF_3$ whilst the deposition is carried out with a polymerisation gas such as $C_4F_8$. $O_2$ may additionally be added during the etching step only. Assuming for example the etch gas to be $SF_6$, then the above equation can be used to calculate $\omega_{pi}$, as shown in Table 1 below.
The following Table 1 shows the ion plasma frequency value of the range of singly charged ions that are possible in the $SF_6^+$ plasma used to etch silicon. The data shows that the ion plasma frequency is in the 5 to 10 MHz range. However, for the relatively low electron temperature and low pressure plasmas in question, the predominant ions will tend to be the $SF_4^+$ and $SF_5^+$. Hence the lower value of ion frequency is most relevant. In the present context, $\omega_{pi}$ (expressed in MHz) will be taken as sub 5MHz.

Table 1: $\omega_{pi}$ of Dominant Singly Charged Ions in an $SF_6$ Plasma Discharge.

| Ionic Species | Ion Plasma Frequency $\omega_{pi}$, in MHz |
|---|---|
| $SF^+$ | 9.31 |
| $SF_2^+$ | 7.84 |
| $SF_3^+$ | 7.05 |
| $SF_4^+$ | 6.40 |
| $SF_5^+$ | 5.90 |

(continued)

| Ionic Species | Ion Plasma Frequency $\omega_{pi}$, in MHz |
|---|---|
| $SF_6^+$ | 5.50 |

It is suggested that the ion charging will reduce as the ions increasingly respond to the rf field, that is at frequencies approaching or below the ion plasma frequency. Thus for bias frequency values of <4 MHz, the ion response to the rf field will reduce the ion charging effects of the silicon surface. This means that during part of the rf cycle, ions will not be accelerated towards the platen which acts as the cathode, so that the electrons can partially neutralise the positive charge accumulation.

Results of pulse modulation of the low frequency bias are shown in Figure 5 and the SEMs in Figures 6A and 6B. This data shows a dramatic reduction in notch size (<150nm per edge in all cases), using 380kHz bias frequency, pulsed width of 2.5 to 5ms, <50% duty cycle. The SEMs and graph also indicate that there is a significant decrease in the rate of increase in notch size as a function of over-etch time. This notch reduction is achieved at lower pressures, and without enhanced passivation, which means an additional step in the process is no longer needed. Most significantly, the SEMs show the result of a single step only now etching at high rates without notching the silicon even after significant over-etching. This also implies that end-point detection is no longer required as there is no second step.

Experiments were carried out over a range of pulse widths (100μs to 5ms) and duty cycles (30% to 100%). The results suggest that the notching is most successfully eliminated for pulse widths <2.5ms for <50% duty cycle, or in other words for pulse off times >2.5ms.

Figure 7 shows the notch size as a function of duty cycle for both 2.5ms and 5ms bias pulse widths. This data is for a 3μm,>5:1 aspect ratio trench. For increasing pulse widths, a lower duty cycle is required to eliminate the notch. In line with the charging model, this suggests that the higher pulse width increases the surface charge, which in turn requires a longer off period for its reduction.

In addition to the notch reduction and charge damage reduction, pulsed rf bias has additional benefits where high levels of ion impact (energy and/or density) onto the workpiece or wafer causes any detrimental effects. There are a number of examples of these benefits in higher selectivity to mask and/or underlying materials and also in the significant reduction to the RIE lag effect.

When etching silicon (single-crystal or poly-crystal) mask materials are typically photoresist or silicon oxide and usually the underlayer is also oxide. Both of these materials have plasma etch rates which are ion energy and density dependent. The role of the ion bombardment is to break the chemical and physical bonds in either the oxide or the cross linked polymeric photoresist material. When the ion energy is below a threshold level, typically less than a few tens of eV (<20eV), very much lower etch rates for these materials can be achieved: If the bonds in the material are not broken, it becomes harder for the chemical etching to proceed. In addition, when the ion energy is at or above the threshold value, the erosion rate can be reduced by pulsing the ions, as now the erosion will largely take place only during part of the cycle when the ions impact the surface. Generally, the lower the duty cycle, the higher the etch selectivity to these materials. Figure 8 shows the increase in etch selectivity of etching between silicon and photoresist as the duty cycle reduces. This is for a 2.5ms pulse width under the conditions stated in the figure. Similar results are obtained for oxide. In conclusion, this means that low frequency pulsed bias can be used to eliminate or reduce notching whilst also enabling high mask and underlayer selectivities. Pulsing here refers to the on-off repetitive switching (defined by pulse width and duty cycle) pulsing of the RF (bias) power during the "on" part of the power supply within the alternating etch/passivation cyclic process.

RIE lag (also known as Aspect Ratio Dependent Etching or ARDE) defines the difference in etch depth observed for features with different opening size or critical dimensions. RIE lag is caused by the increasing difficulty of reactive precursor and product species in reaching and leaving the etching front or base of the trench as the aspect ratio increases. The net effect is that higher aspect ratio features etch at a lower rate as compared to lower aspect ratio features. The present invention may provide a reduction or indeed elimination of the RIE lag. As the duty cycle is reduced, the etch rate of the silicon is observed to reduce. See Figure 9, which presents data for 2.5ms pulse width and for 3 to 50μm trench widths. However, the etch rate does not decrease at the same rate for all aspect ratios. Indeed, the trend shows that at 40% duty cycle for the 2.5ms pulse width, all of the features etch at the same rate, resulting in zero RIE lag or ARDE. The reason for this requires an understanding of the details of the cyclic etch and passivation process. During the passivation step, the protective polymer is deposited on all of the surfaces that are exposed to the plasma. But, both the thickness of the deposition in the bases of the trenches and the step coverage depend on the aspect ratio. As the aspect ratio increases, transport limitations ensure that the passivation reduces on the base of the trench. In other words, more deposition is present in the wide trenches compared to the narrow trenches. Now, this means that more passivation has to be removed in wider trenches before silicon etching can take place. So, although the etch rate in the wider features is actually still higher, the net effect of the etch and passivation (removal and deposition) is to equalize the etch rates of the narrow and wide features. This RIE lag compensation effect can be achieved by a number of ways which allow judicious balance of the etch and deposition conditions to achieve the same effect. Pulsed RF bias also demonstrates this effect. Figure 9 shows the etch rate as a function of duty cycle at a 2.5ms pulse width for trench widths ranging from 3 to 50μm. The etch rate decreases as the duty cycle reduces. The rate of decrease reduces with trench width as the duty cycle reduces, until at 40% the rates are similar resulting in a zero RIE 1ag or ARDE.

A method for RIE lag reduction and elimination has been discussed above. The key step is to increase the ratio of deposition in wider trench with respect to narrow trench. Typically, the ratio is >1, and the disclosed method is to further increase the ratio. Pulsed biasing has been used to achieve this. It is also possible to use other means of achieving the same effect and hence the same result, including parameter ramping.

Figure 20a shows the RIE lag between a 2μm and 5μm trench etched to 40μm deep. Fig 20b shows the elimination of the RIE lag using the method of increasing the ratio of deposition in the wider trench with respect to the narrow trench. Fig 20c shows an inverse RIE lag achieved by further increasing this ratio. This was achieved using parameter ramping (for example as disclosed in EP-A-0822582 or EP-A-0822584). The table below presents the process conditions (ramped) in order to achieve this.

Example of scheme used to control RIE lag

| **Stage** | **Etch bias power (W)** | **Etch step gas flows (sccm)** | **Switching Order** | **Stage Duration (min:sec)** |
|---|---|---|---|---|
| 1 | 4 | $SF_6$: 150<br>$C_4F_8$: 25 | (PE) x 4 +0.5P | 1:24 |
| 2 | 4 | $SF_6$: 150<br>$C_4F_8$: 18 | P + (EP) x 2 | 0:48 |
| 3 | 4.5 | $SF_6$: 150<br>$C_4F_8$: 10 | PE... | 20:48 |
| (ramp 1sccm $C_4F_8$ flow each step) | 4.5 | $SF_6$: 150<br>$C_4F_8$: ⇓ | PE... | |
| | | $SF_6$: 150<br>$C_4F_8$: ⇓ | PE... | |
| | | $SF_6$: 150<br>$C_4F_8$: ⇓ | PE... | |
| | | $SF_6$: 150<br>$C_4F_8$: 0 | PE... | |

Figure 21 shows results obtained using low frequency pulsed biasing. Figures 21a to 21d show the RIE lag reduction as the duty cycle decreases from 70% to 40% for a 2-5ms pulse width. Note also the modification to the etched trench profile.

The ion bombardment of the wafer also influences the passivation on the sidewall (a part of the step coverage). This in turn plays a key role in controlling the sidewall angle of the etched trench. Generally, increasing the passivation or reducing the passivation removal rate reduces the angle of the trench, where angles less than 90 degrees represents positive tapered trenches and angles >90 degrees represents re-entrant tapered trenches. The effect of decreasing the duty cycle (of a 2.5ms pulse) on the profile is shown in Figure 10 for 3μm to 50μm trench widths. This shows that RF bias pulsing can be effectively used to precisely control the sidewall of the trench. Very similar results were obtained for a 5ms pulse width. These trends indicate that duty cycle reduction effectively decreases the passivation removal by the ions from the sidewall of the trench.

Figure 11 shows a circuit to pulse rf fed to a platen.

The apparatus comprises a chamber 8 having a platen 9 on which is positioned a wafer or workpiece 10. The chamber 8 also includes a dielectric window 11 surrounded by an ICP coil 12. Gas may be fed into chamber 8 through inlet 13 and may be pumped out through outlet 14. In the embodiment shown, the ICP coil 12 is connected to a matching unit 15 which in turn is connected to a CW RF power supply 16. The platen 9 is connected to a matching unit 17 which is connected to an RF power supply 18 which in turn is connected to a pulse generator 19.

A pulsed DC potential applied to a platen may be used in place of pulsed RF applied to the platen if the workpiece is sufficiently conducting, or is of a form where most of the material is conducting but a thin insulating layer may exist within the structure.

The circuit shown in Figure 12 allows the DC potential applied to the platen to be pulsed between two values. Typically in a plasma processing apparatus the potentials may be:

1) sufficiently negative with respect to plasma potential to accelerate positive ions towards the surface of the workpiece, giving them a narrow angular distribution and adequate energy to etch the material.
2) slightly negative with respect to the plasma potential (close to floating potential) in order to form a sheath through which ions are accelerated, but to relatively low energy, so that their angular distribution is large, and they can play a significant role in negative charge cancellation.

The "on time" for the more negative bias level, and the relative length of times for which the platen is biassed to either DC potential, can be chosen as for pulsed RF bias of the platen. The smaller negative potential will generally be chosen to be close to the floating potential reached during the off period for the pulsed RF bias, but the circuit shown in figure 12 would allow other choices of potential and therefore ion energy and angular distribution.

In some circumstances, in place of the smaller negative potential part of the pulse cycle, a positive potential may be used in order to deliberately accelerate electrons and potentially negative ions to the workpiece to aid in the discharge mechanism, and to repel positive ions. The acceleration of electrons towards the workpiece may result in a reduction in the time required to carry out the discharge function, thereby allowing the etch part of the pulsed cycle to be increased, resulting in higher overall etch rates.

In Figure 12, reference numerals of Figure 11 refer to identical components, where these are present. Where Figure 12 differs is the provision of a DC power amplifier 20 connected to platen 9. A pulse generator 21 is connected to the amplifier 20.

An alternative circuit to that shown in Figure 12 might employ a DC power supply to provide the more negative bias potential, with a suitable electronic switch connected between it and the platen. The switch would be controlled by a pulse generator, and would either switch between closed and open states (in open state the platen potential would reach local floating potential), or would change over to allow the bias to be provided alternately by a second DC power supply.

Details of the bias options are shown in Figure 13.

The application of pulsed DC potentials to the platen will have benefits when processing workpieces which are conducting or semiconducting. The technique may also be used for workpieces which contain thin insulating layers, such that the capacitance of the layer is large enough to make the RC time constant of the order of the repetition rate of the potential pulsing.

As an example, a wafer may consist of silicon with a thin, of order 1μm thick, silicon oxide layer. On top of this layer is a further thicker layer of silicon.

Parallel plate capacitor:

$$C = \epsilon_o \epsilon_r A/d$$

where A = plate area,
d = distance between plates,
$\epsilon_o$ = permittivity of free space,
$\epsilon_r$ = relative permittivity.

For a 150mm wafer A = 0.0177$m^2$ d = $1x10^{-6}$m

$$\epsilon_o = 8.854x10^{-12}\ F/m\ \epsilon_r = 4,$$

typical value for oxide layer, but is material specific.

Therefore C = 6.3 x $10^{-7}$ F

For a plasma resistance of approximately 10Ω the RC time constant ≈ $6x10^{-6}$ seconds.

To ensure that the potential on the surface exposed to the plasma follows the applied potential to a reasonable degree, pulse lengths would need to be approximately 10μs. For a thinner insulating layer and higher capacitance, pulse lengths could increase.

This invention relates to methods of reduction of surface charge which can build up during plasma etching. As such, it is therefore also applicable to cases where charge build causes detrimental effects when etching electrically insulating substrates such as glass, quartz, sapphire, zirconia and the like. When etching these materials in a plasma discharge, detrimental effects including "pitting" damage or erosion (as shown in Figure 15) and loss in profile anisotropy (as shown in Figure 16) can occur as a result of surface charging. Pulsing the rf bias to reduce this surface charge directly improves the etching result by reducing both of those detrimental effects. Figure 17 demonstrates this for a deep quartz etch where the profile anisotropy is still maintained using low frequency rf bias pulsing with a 12ms pulse off width and a 50% duty cycle.

Process Conditions

| Parameter | Fig 15 | Fig 16 | Fig 17 |
|---|---|---|---|
| Gas 1 Flow Rate, sccm | $C_3F_8$:30 | $C_3F_8$:40 | $C_3F_8$:40 |
| Gas 2 Flow Rate, sccm | | $O_2$:10 | $O_2$:10 |
| Pressure, mTorr | 3 | 4 | 4 |
| RF Coil Power, W (13.56 MHz) | 600 | 800 | 800 |
| RF Bias Power, W (13.56 MHz) | 250 | 150 | - |
| Platen Temperature, °C | 20 | 20 | 20 |
| Process Time, mins | 5 | 20 | 45 |
| RF Bias Power, W (380kHz pulsed) | - | - | 150, 12ms on 50% Duty Cycle |

To achieve etching of trenches with parallel sidewalls, it is important that ions impinge on the substrate normal to its surface. For this to occur at all positions on the substrate, the ions must all be accelerated through an electric field which has little or no component parallel to the surface of the substrate.

Under normal operating conditions, in an inductively coupled plasma tool, (also true of tools using other plasma generation sources such as ECR, Helicon, Helical resonator), the electrode supporting the substrate is driven by a RF power supply. A negative bias is developed on the substrate and ions are accelerated across the space charge sheath from the plasma to the surface of the substrate. In an ideal situation the potential would be the same at all points on the surface of the substrate. However, in a real situation, there will be variations in potential, and therefore electric field components set up, across the surface of the substrate. The components of the electric field parallel to the surface of the substrate result in ion trajectories that are no longer normal to the substrate surface.

When the ions involved in trench etching are deflected by a component of the electric field that is parallel to the substrate surface, they may impinge on the sidewall of a trench. This leads either directly or indirectly to localised etching of the sidewall, resulting in a "beaking effect" with profile asymmetry, as shown in Figure 18. The low RF bias power levels used makes this effect much worse for the alternate etch/deposition step, for example as disclosed in EP-A-0822582 and EP-A-0822584.

The construction of the RF driven electrode must satisfy certain criteria in terms of vacuum integrity and provision of electrical insulation between RF driven and grounded components. For a practical electrode, the connection of RF power may be towards the centre of the electrode and clamping together of driven and grounded components, with an insulator between, may be towards the edge. This arrangement while practical to construct, has the potential disadvantage that RF power may be capacitively coupled from the driven platen (top part of the electrode on which the substrate is supported), to the grounded components at the edge of the electrode assembly. The supplying of RF power to the electrode near the centre, and the capacitive coupling of some of this power to ground near the edge, can result in an appreciable voltage gradient between centre and edge of the electrode. In greater detail, this is because the arrangement acts as a potential divider with the potential at a particular location on the electrode determined by the relative magnitudes of the impedances between the point at which RF power is applied and the grounded components of the electrode assembly. The capacitance between RF driven and grounded components at the edge of the electrode can be reduced to some extent by geometrical modifications, but there are practical limits. Simply applying the RF power towards the edge of the electrode may reduce the problem, but is not an adequate solution, particularly when the RF power is at high frequency (≥ 13.56 MHz). As the RF frequency is decreased, the degree of capacitive coupling at the electrode edge between driven and grounded components decreases. This is because the reactance due to this capacitance varies as 1/(ωC), where w is the angular frequency (ω)=2πf) and C is the capacitance. As the frequency is reduced, the reactance between RF driven and grounded components near the edge of the electrode, will increase and therefore because of the potential divider effect described above, the potential variation across the electrode should decrease.

Variations in potential across the electrode will produce electric fields that will deflect ions in the direction of the field. Since etched trenches are observed to exhibit the "beaking effect" on both side walls, with some asymmetry, the potential gradient across the electrode, described above, can not be totally responsible for the result. It is believed that at least some proportion of the "beaking effect" (notches in the side walls of trenches, below and close to the mask or resist layer) is due to a second factor of charging of the edges of the resist or masking layer. This layer normally is an insulator, or less conductive than the silicon underlying it, and therefore may retain localised charging. In this context, as in the context of notching at an insulating layer at the bottom of a trench, it is believed that the edges of the resist or mask above the silicon, are charged negative by a local excess of electrons. The argument for this is essentially as stated before in terms of the ions having greater directionality towards the substrate surface, and into the trenches, while the electrons have a more isotropic directionality. A localised negative charge at the edges of the resist/mask will lead to positive ion deflection towards and into the sidewalls of the trench. The ions will either directly remove silicon leading to the "beaking effect", or with regard to the process in EP-A-0822582 and EP-A-0822584, may locally remove the passivating layer, allowing localised chemical etching of the silicon. For exactly the same reasons stated with regard to the notching problem at an insulating layer at the bottom of a trench, the choice of reduced frequency for the RF bias will lead to ions with a greater spread of energies and directions, some of which will impinge on the edges of the resist/mask, thereby partially cancelling the negative charge. The reduction in negative charge on the edges of the resist/mask leads to a reduction in the "beaking effect". For the same reasons as stated previously with respect to the notching at an insulating layer at the bottom of a trench, pulsing of the bias supply is expected to reduce the "beaking" effect still further.

The "beaking effect" becomes more significant as the plasma density is increased to achieve higher etch rates. Because of this, both biasing of the electrode at low frequency and pulsing of this supply, are expected to be necessary to achieve a reduction of the "beaking effect" at high plasma densities. Figure 18 shows the "beaking effect" for a 30μm wide trench. The "beaking effect" has been observed to be a function of trench width and the closeness of packing of trenches. For elimination or reduction of the "beaking effect" in all trench configurations, it is unlikely that either low frequency bias or pulsing of the RF supply would be sufficient alone, and both will be required.

As mentioned above, it is considered that two different factors contribute to the "beaking effect": (1) a potential gradient across the electrode, and (2) a localised negative charging of the resist/mask. Reducing the frequency of the RF power used to provide the electrode bias will reduce both of these factors. Results are shown in the table below, which is a summary of experimental measurements carried out with RF frequencies of 13.56 MHz and 380 kHz. It is clear from this table and the SEMs in figure 18 taken for a RF frequency of 13.56 MHz and figure 19 at 380 kHz, that the degree of "beaking" and the asymmetry, is dramatically reduced by the move to lower frequency operation.

processing conditions ICP power 2500 W etch step, 1500 W deposition step

| **Run** | **Mask Remaining (μm)** | **Wafer <=Edge "beaking" Left, Right (μm)** | **Wafer Centre "beaking" Left, Right (μm)** | **Si Etch rate (μm/min)** |
|---|---|---|---|---|
| Standard 13.56 MHz arrangement 12 W | 1.5 - 2.0 | 3, 2.2 | 1, 1.61 | 3 |
| 12 W, 380 k Hz RF frequency | 2.16, 2.6 | 0.6, 0.5 | 0.1, 0.2 | 3.17 |

2.7 μm photo-resist mask thickness before etch

## Claims

1. A method of etching a feature in a substrate (1,10) in a chamber (8) in which the substrate comprises an insulating underlayer (3), the method comprising alternately etching a semiconductor or conductor by means of a plasma and depositing a passivation layer by means of a plasma, wherein, during the etching step, a bias voltage is applied to the substrate, in which the bias voltage is not pulsed and has a frequency which is at or below the ion plasma frequency so as to reduce or eliminate localised etching of the substrate or charge damage at the interface of the semiconductor or conductor with the insulating underlayer, **characterised in that** the method further comprises: a further etching and passivation step which is carried out after the alternative etching and deposition step and at a higher pressure than the alternate etching and deposition step in order to enhance the passivation thereby reducing notching; and an end-point detection step to determine when to switch from the alternate etching and deposition first step to the further etching and passivating step.

2. A method according to claim 1, wherein the etching and passivation step carried out at a higher pressure is started when the underlayer is approached.

3. A method of etching a feature in a substrate (1,10) in a chamber (8) in which the substrate comprises an insulating underlayer (3), the method comprising alternately etching a semiconductor or conductor by means of a plasma and depositing a passivation layer by means of a plasma, **characterised in that** during the etching step a pulsed RF bias voltage having an RF bias frequency is applied to the substrate in order to reduce or eliminate notching.

4. A method according to claim 3 in which the RF bias frequency applied to the substrate is at or below the ion plasma frequency.

5. A method according to any preceding claim, wherein the bias voltage is produced by an RF bias power supply (18,20).

6. A method according to any preceding claim, wherein the substrate is a semiconductor.

7. A method according to any preceding claim, wherein the substrate comprises a masking layer (4) on its upper surface.

8. A method according to claim 7, wherein the masking layer is an insulator.

9. A method according to any preceding claim, wherein the bias voltage has a frequency which is at or below 4MHz.

10. A method according to claim 9, wherein the bias voltage has a frequency which is in the range of 50kHz to 380kHz.

11. A method according to claim 3 or any one of claims 4 to 10. when dependent on claim 3, in which the pulsed RF bias voltage has a duty cycle defined by the ratio of pulse on time to pulse off time, and wherein the pulse off time is greater than 100μs.

12. A method according to claim 3 or any one of claims 4 to 11. when dependent on claim 3, in which the pulsed RF bias voltage has a duty cycle defined by the ratio of a pulse on time to pulse off time, and wherein the pulse off time is applied for between 10% to 90% of the time.

13. A method according to any preceding claim, wherein the ratio of deposition in a wider trench with respect to a narrower trench is increased to reduce or eliminate RIE lag.

14. A method according to claim 13, wherein pulsed ions are used.

15. A method according to any preceding claim, further comprising the step of providing a magnetic filter to partially or completely divide the volume of the chamber in which the plasma is formed from the volume in which the substrate is positioned.

## Patentansprüche

1. Verfahren zur Ätzung eines Merkmals in einem Substrat (1, 10) in einer Kammer (8), wobei das Substrat eine isolierende Unterschicht (3) aufweist, umfassend abwechselndes Ätzen eines Halbleiters oder Leiters mit Hilfe eines Plasmas und Abscheidung einer Konservierungsschicht mit Hilfe eines Plasmas, wobei während des Ätzschrittes an das Substrat eine Spannung angelegt wird, die nicht impulsförmig ist und eine Frequenz aufweist, die der Ionen-plasmafrequenz entspricht oder unter ihr liegt, um das lokalisierte Ätzen des Substrats oder den Ladungsschaden an der Grenzfläche des Halbleiters oder Leiters mit der isolierenden Unterschicht zu verringern oder zu vermeiden, **dadurch gekennzeichnet, daß** das Verfahren des weiteren umfaßt einen weiteren Ätz- und Passivierungsschritt, der nach dem abwechselnden Ätzen und dem Abscheidungsschritt stattfindet sowie bei einem höheren Druck als beim abwechselnden Ätzen und Abscheiden, um die Passivierung zu verstärken und **dadurch** die Kerbenbildung zu verringern; sowie einen Endpunkt-Ermittiungsschritt, um zu bestimmen, wenn von dem abwechselnden Ätzen und dem ersten Abscheidungsschritt zu dem weiteren Ätzen und Passivierungsschritt geschaltet wird.

2. Verfahren nach Anspruch 1, **dadurch gekennzeichnet, daß** das Ätzen und der Passivierungsschritt bei einem höheren Druck begonnen wird, sobald sich die Unterschicht nähert.

3. Verfahren zur Ätzung eines Merkmals in einem Substrat (1,10) in einer Kammer (8), wobei das Substrat eine isolierende Unterschicht (3) aufweist, umfassend abwechselndes Ätzen eines Halbleiters oder Leiters mit Hilfe eines Plasmas und Abscheiden einer Passivierungsschicht mit Hilfe eines Plasmas, **dadurch gekennzeichnet, daß** während des Ätzschrittes eine gepulste Hochfrequenzspannung an das Substrat angelegt wird, um Kerbenbildung zu verringern oder zu beseitigen.

4. Verfahren nach Anspruch 3, **dadurch gekennzeichnet, daß** die Hochfrequenzspannung, die an das Substrat angelegt wird, bei der oder unter der Ionenplasmafrequenz liegt.

5. Verfahren nach einem der vorhergehenden Ansprüche, **dadurch gekennzeichnet, daß** die Vorspannung durch eine Hochfrequenzstromquelle (18, 20) erzeugt wird.

6. Verfahren nach einem der vorhergehenden Ansprüche, **dadurch gekennzeichnet, daß** das Substrat ein Halbleiter ist.

7. Verfahren nach einem der vorhergehenden Ansprüche, **dadurch gekennzeichnet, daß** das Substrat auf seiner oberen Oberfläche eine Maskenschicht (4) aufweist.

8. Verfahren nach Anspruch 7, **dadurch gekennzeichnet, daß** die Maskenschicht ein Isolator ist.

9. Verfahren nach einem der vorhergehenden Ansprüche, **dadurch gekennzeichnet, daß** die Vorspannung eine Frequenz aufweist, die bei oder unter 4 MHz liegt.

10. Verfahren nach Anspruch 9, **dadurch gekennzeichnet, daß** die Vorspannung eine Frequenz aufweist, die im Bereich von 50 KHz bis 380 KHz liegt.

11. Verfahren nach Anspruch 3 oder irgendeinem der Ansprüche 4 bis 10 in Abhängigkeit von Anspruch 3, **dadurch gekennzeichnet, daß** die gepulste Hochfrequenzspannung einen Arbeitszyklus hat, der durch das Verhältnis von Impulseinschaltzeit zu Impulsabschaltzeit bestimmt wird, wobei die Impulsabschaltzeit größer ist als 100 $\mu$sec.

12. Verfahren nach Anspruch 3 oder irgendeinem der Ansprüche 4 bis 11 in Abhängigkeit von Anspruch 3, **dadurch gekennzeichnet, daß** die gepulste Hochfrequenzspannung einen Arbeitszyklus hat, der durch das Verhältnis der Impulseinschaltzeit zu Impulsabschaltzeit bestimmt wird, wobei die Impulsabschaltzeit zwischen 10 % bis 90 % der Zeit beträgt.

13. Verfahren nach einem der vorhergehenden Ansprüche, **dadurch gekennzeichnet, daß** das Abscheidungsverhältnis in einem breiteren Graben in Bezug auf einen schmaleren Graben erhöht wird, um Ätzverzögerung zu verringern oder zu beseitigen.

14. Verfahren nach Anspruch 13, **dadurch gekennzeichnet, daß** gepulste Ionen Verwendung finden.

15. Verfahren nach einem der vorhergehenden Ansprüche, ferner **gekennzeichnet durch** den Schritt der Schaffung eines magnetischen Filters, um das Kammervolumen, in dem das Plasma ausgebildet wird, teilweise oder vollständig von dem Volumen zu trennen, in dem das Substrat angeordnet wird.

## Revendications

1. Procédé de gravure d'une caractéristique dans un substrat (1, 10) dans une chambre (8), le substrat comprenant une sous-couche isolante (3), le procédé comprenant de façon alternée la gravure d'un semi-conducteur ou d'un conducteur au moyen d'un plasma et le dépôt d'une couche de passivation au moyen d'un plasma, dans lequel procédé, lors de l'étape de gravure, une tension de polarisation est appliquée au substrat, la tension de polarisation n'étant pas pulsée et ayant une fréquence qui est inférieure ou égale à la fréquence du plasma ionique de façon à réduire ou éliminer la gravure localisée du substrat ou une détérioration due à la charge à l'interface du semi-conducteur ou du conducteur avec la sous-couche isolante, **caractérisé par le fait que** le procédé comprend en outre : une étape supplémentaire de gravure et de passivation qui est réalisée après l'étape de gravure et de dépôt en alternance et à une pression plus élevée que pour l'étape de gravure et de dépôt en alternance dans le but d'améliorer la passivation et ainsi de réduire l'encochage ; et une étape de détection de point d'extrémité pour déterminer quand passer de la première étape de gravure et de dépôt en alternance à l'étape supplémentaire de gravure et de passivation.

**2.** Procédé selon la revendication 1, dans lequel l'étape de gravure et de passivation réalisée à une pression plus élevée est commencée lorsque la sous-couche est approchée.

**3.** Procédé de gravure d'une caractéristique dans un substrat (1, 10) dans une chambre (8), le substrat comprenant une sous-couche isolante (3), le procédé comprenant de façon alternée la gravure d'un semi-conducteur ou d'un conducteur au moyen d'un plasma et le dépôt d'une couche de passivation au moyen d'un plasma, **caractérisé par le fait que** pendant l'étape de gravure, une tension de polarisation RF pulsée ayant une fréquence de polarisation RF est appliquée au substrat dans le but de réduire ou d'éliminer l'encochage.

**4.** Procédé selon la revendication 3, dans lequel la fréquence de polarisation RF appliquée au substrat est inférieure ou égale à la fréquence du plasma ionique.

**5.** Procédé selon l'une quelconque des revendications précédentes, dans lequel la tension de polarisation est produite par une alimentation électrique de polarisation RF (18, 20).

**6.** Procédé selon l'une quelconque des revendications précédentes, dans lequel le substrat est un semi-conducteur.

**7.** Procédé selon l'une quelconque des revendications précédentes, dans lequel le substrat comprend une couche de masquage (4) sur sa surface supérieure.

**8.** Procédé selon la revendication 7, dans lequel la couche de masquage est un isolant.

**9.** Procédé selon l'une quelconque des revendications précédentes, dans lequel la tension de polarisation a une fréquence qui est inférieure ou égale à 4 MHz.

**10.** Procédé selon la revendication 9, dans lequel la tension de polarisation a une fréquence qui se situe dans la gamme allant de 50 kHz à 380 kHz.

**11.** Procédé selon la revendication 3 ou l'une quelconque des revendications 4 à 10 prises en dépendance de la revendication 3, dans lequel la tension de polarisation RF pulsée a un rapport cyclique défini par le rapport durée des impulsions sur durée hors impulsions, et dans lequel la durée hors impulsions est supérieure à 100 $\mu$s.

**12.** Procédé selon la revendication 3 ou l'une quelconque des revendications 4 à 11 prises en dépendance de la revendication 3, dans lequel la tension de polarisation RF pulsée a un rapport cyclique défini par le rapport durée des impulsions sur durée hors impulsions, et dans lequel la durée hors impulsions est appliquée entre 10 % et 90 % du temps.

**13.** Procédé selon l'une quelconque des revendications précédentes, dans lequel le rapport de dépôt dans une tranchée plus large par rapport à une tranchée plus étroite est augmenté pour réduire ou éliminer un ralentissement de gravure ionique réactive.

**14.** Procédé selon la revendication 13, dans lequel des ions pulsés sont utilisés.

**15.** Procédé selon l'une quelconque des revendications précédentes, comprenant en en outre l'étape de disposition d'un filtre magnétique pour séparer partiellement ou complètement le volume de la chambre dans laquelle le plasma est forme du volume dans lequel le substrat est positionné.

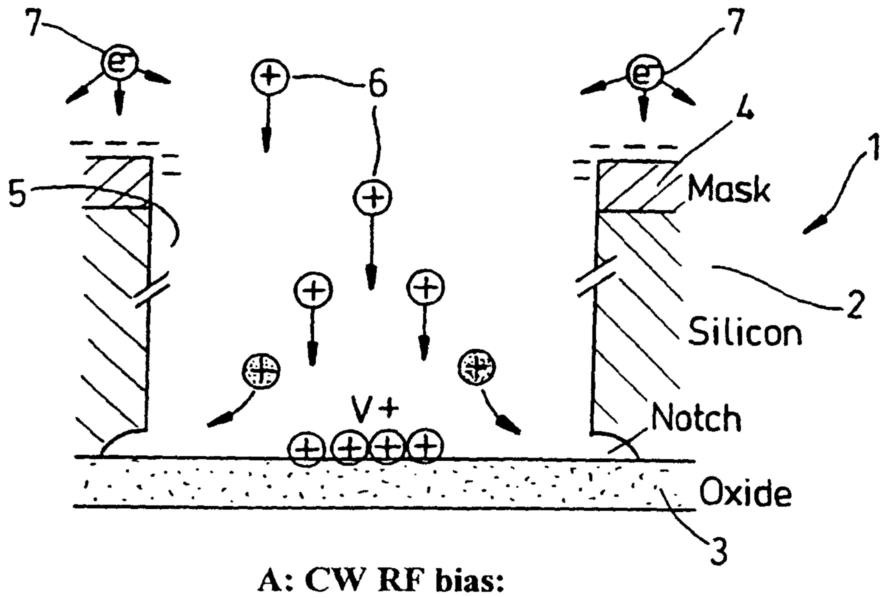


**A: CW RF bias:**

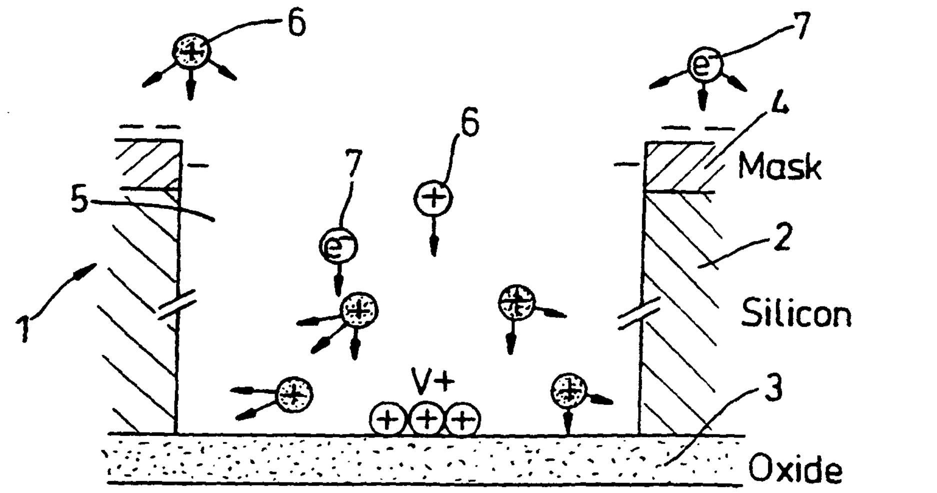


**B: Pulsed RF bias off cycle (or during the off cycle in pulsed source):**

***Fig. 1***

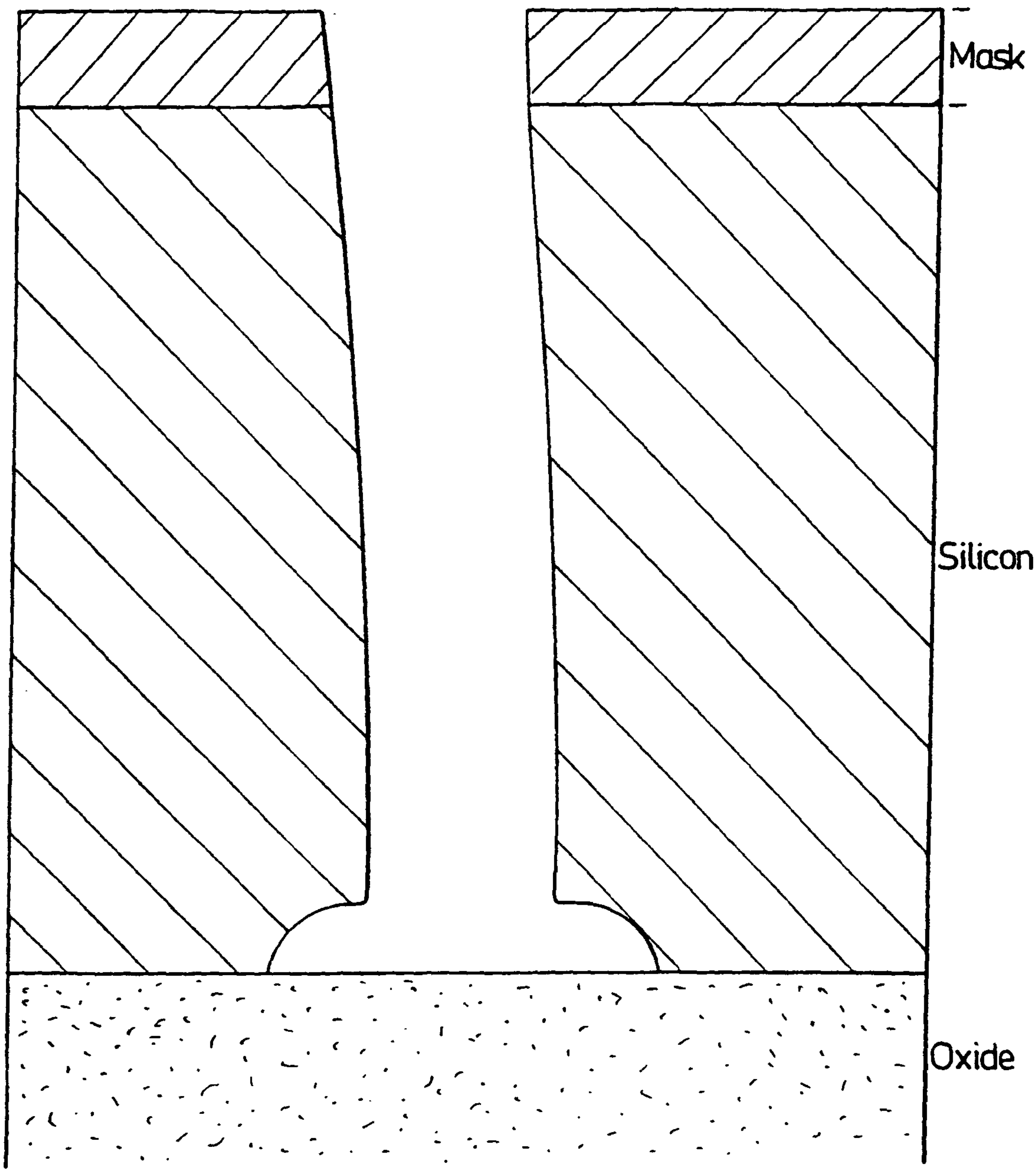


**Notching of silicon at oxide interface**
**13.56 MHz bias frequency**
**step 1 only**

***Fig. 2a***

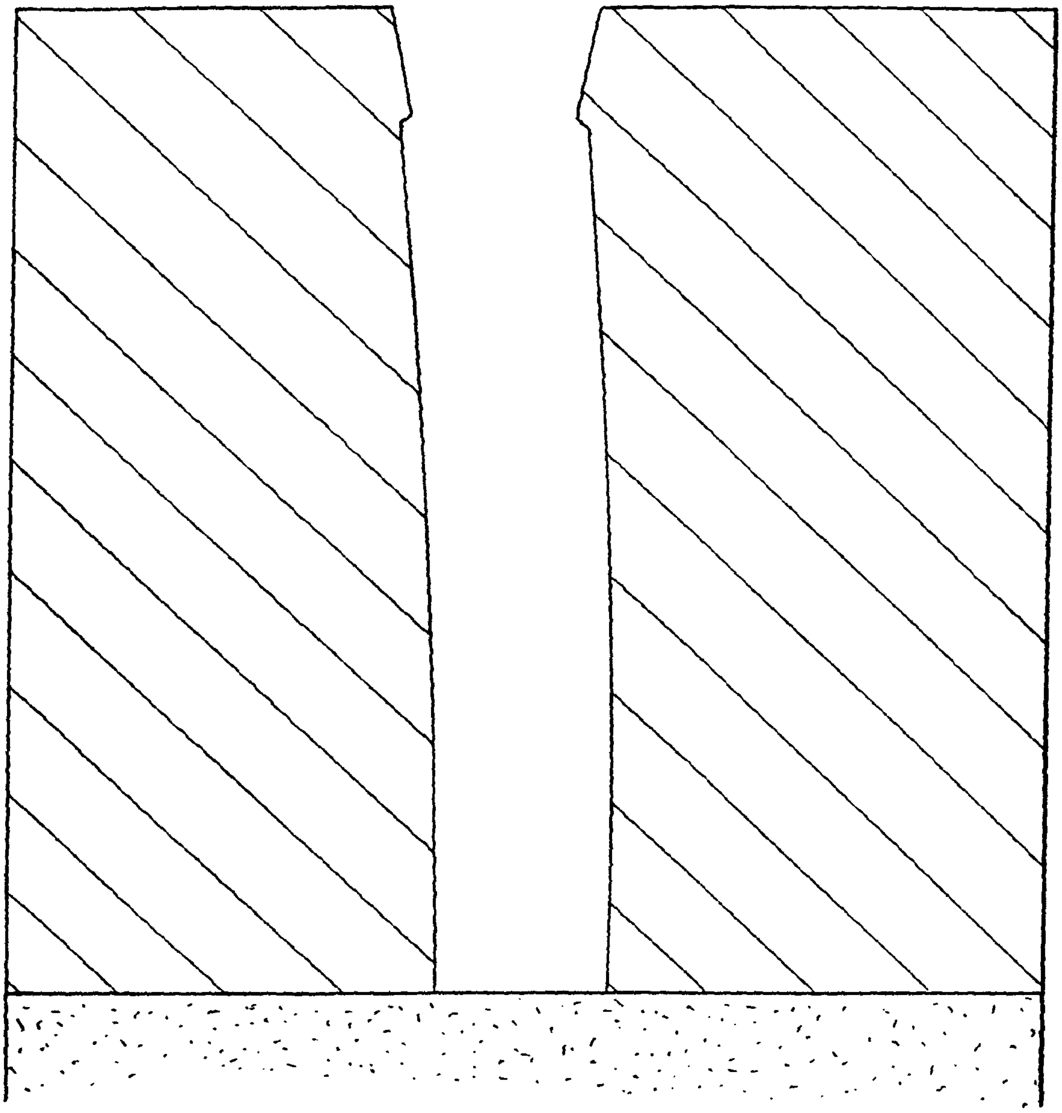

**Profile without notching, obtained by using 2 step process. 2nd step at higher pressure and higher passivation level. 13.56 MHz bias frquency. Step 1 and step 2.**

***Fig. 2b***

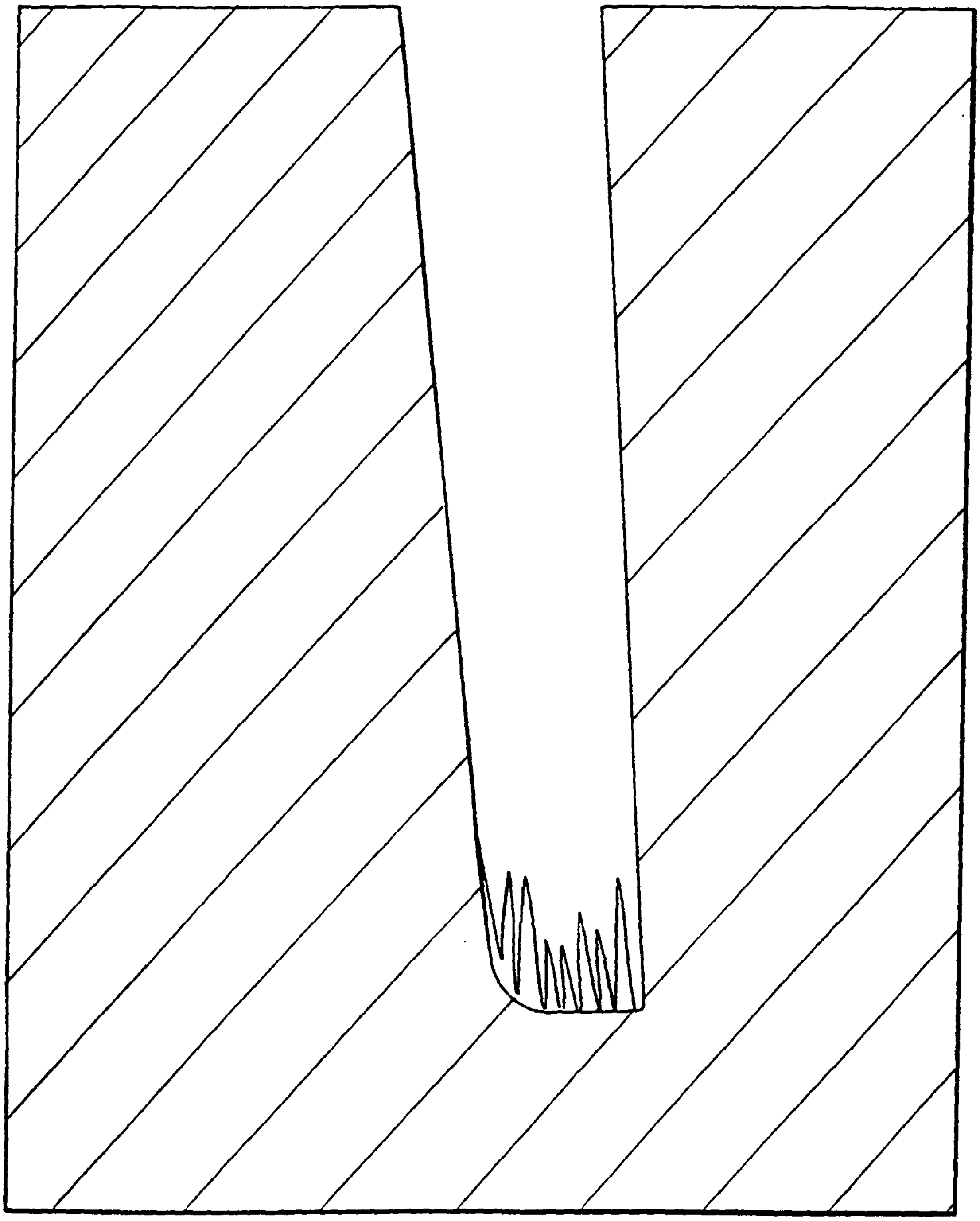

**Grass formation if step 2 is used for too great a depth. 13.56 MHz**

***Fig. 3***

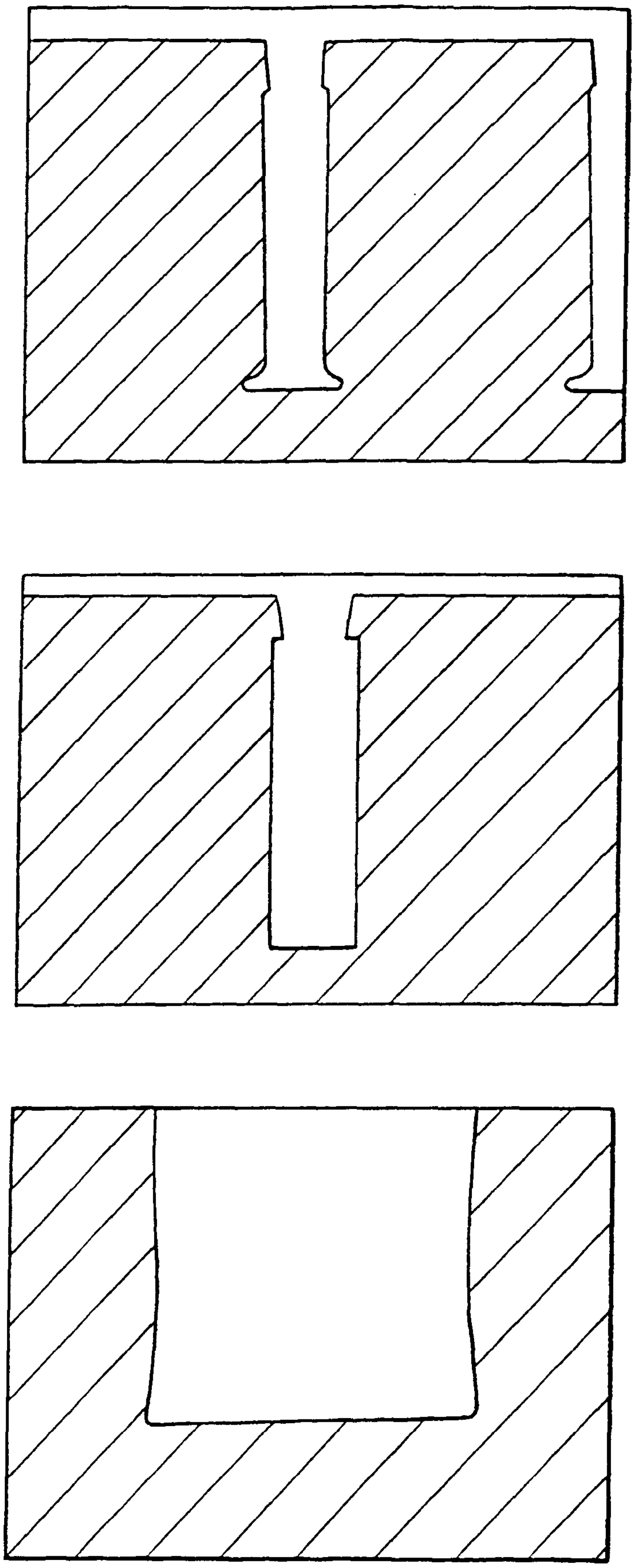

*A*

**Low frequency continuous step 1 only**

*B*

**Low frequency continuous step 1 and step 2**

*C*

***Fig. 4***

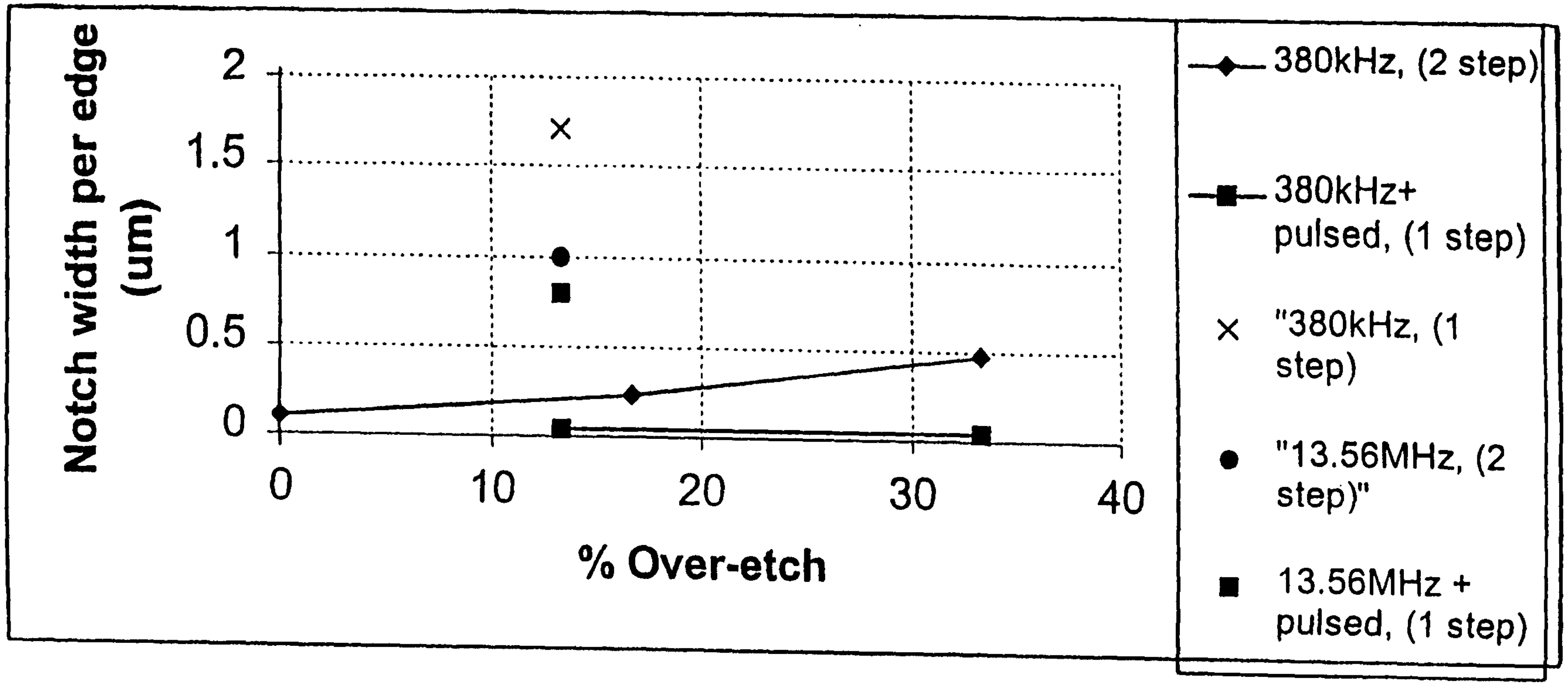


Notch width variation for 380kHz (pulsed and unpulsed), 13.56MHz (pulsed and unpulsed) wafer bias cases.

*Fig. 5*

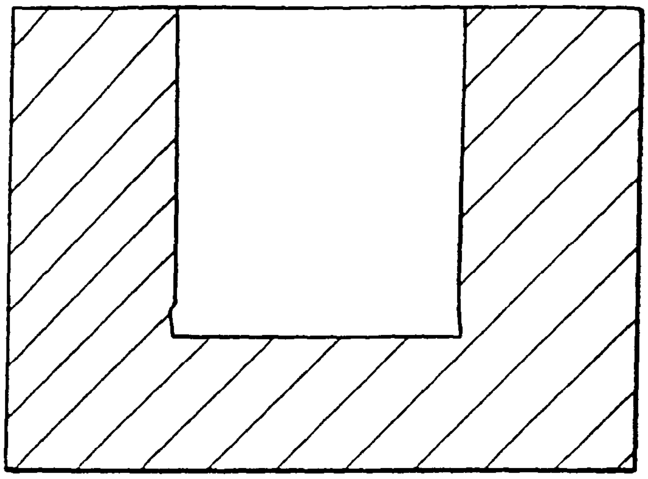

Base of trench at edge of wafer after 2 minutes overetch.
380kHz wafer bias frequency, pulsed at typically 5ms cycle time, 50% duty cycle, one step process.

*Fig. 6a*

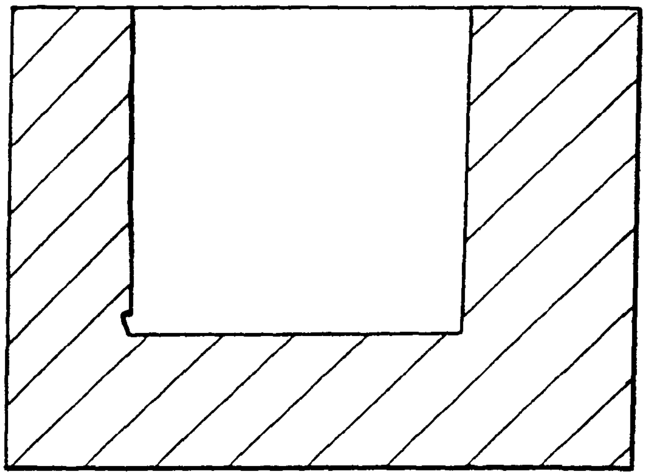

Base of trench at edge of wafer after 5 minutes overetch. 380 kHz wafer bias frequency, pulsed at typically 5ms cycle time, 50% duty cycle, one step process.

*Fig. 6b*

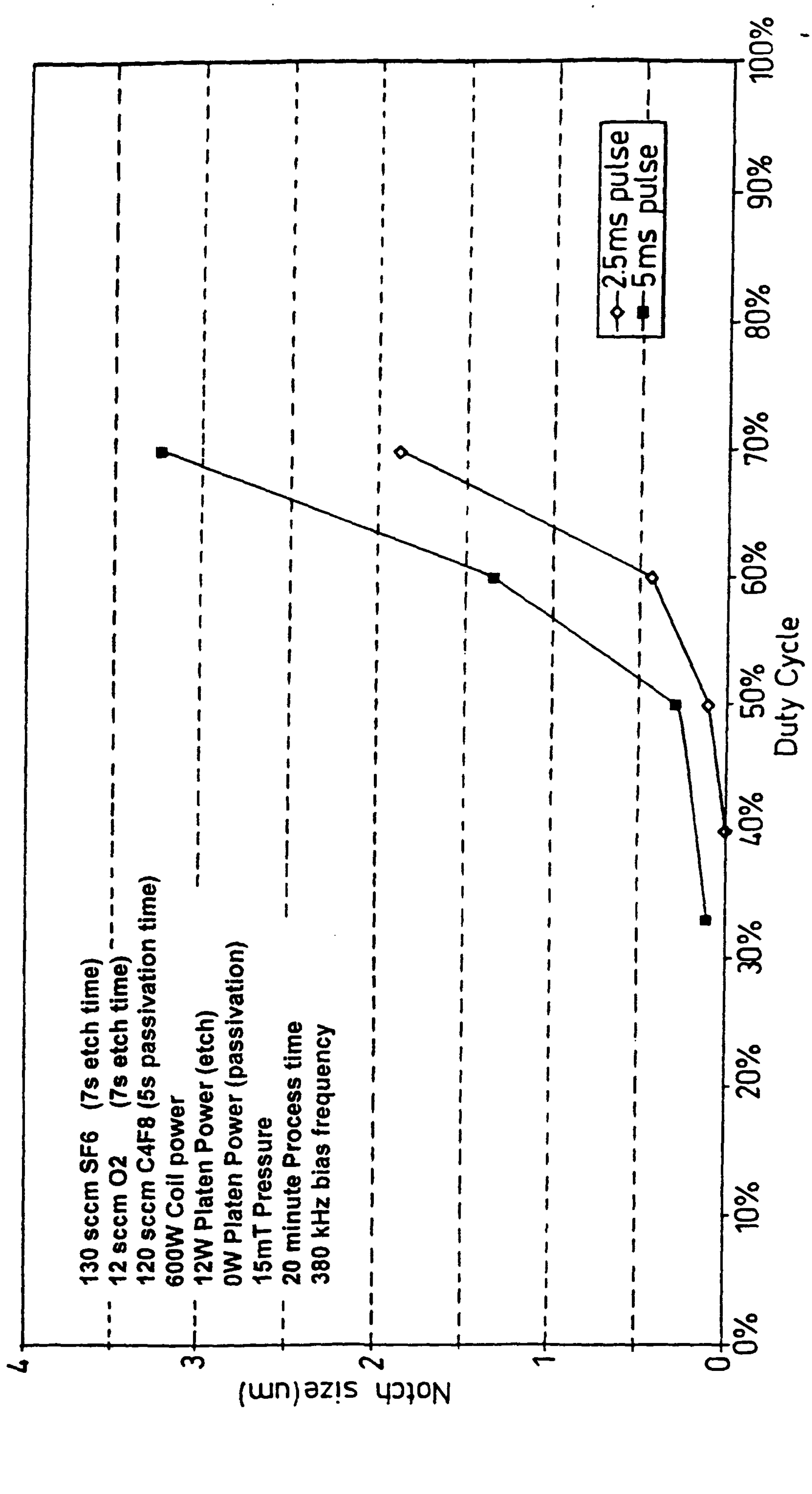


*Fig. 7* **Variation of notch size with duty cycle (SOI, 3µm trench)**

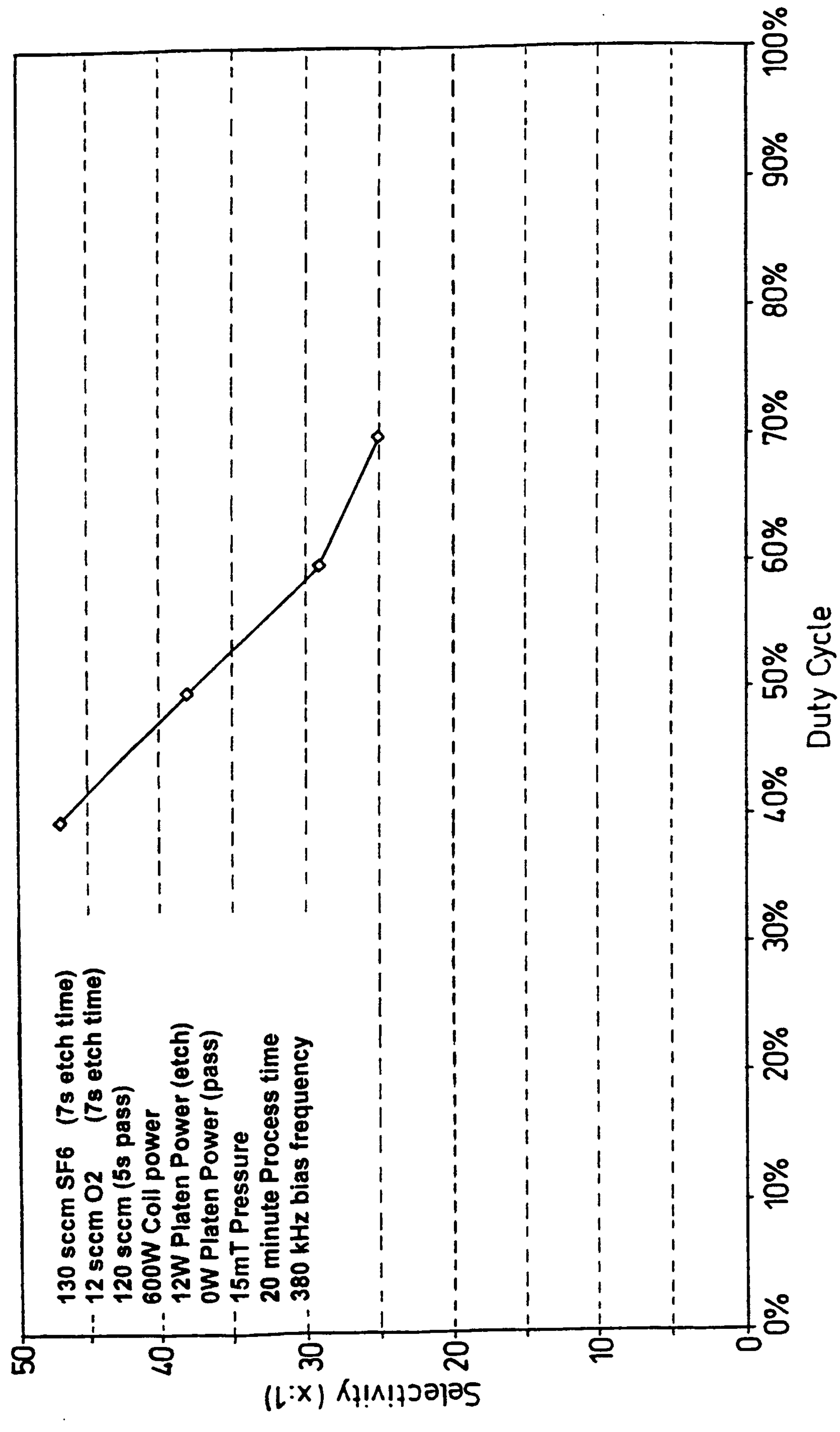


*Fig. 8* **Variation of selectivity with duty cycle (Bulk, 2.5ms pulse, 10µm trench width)**

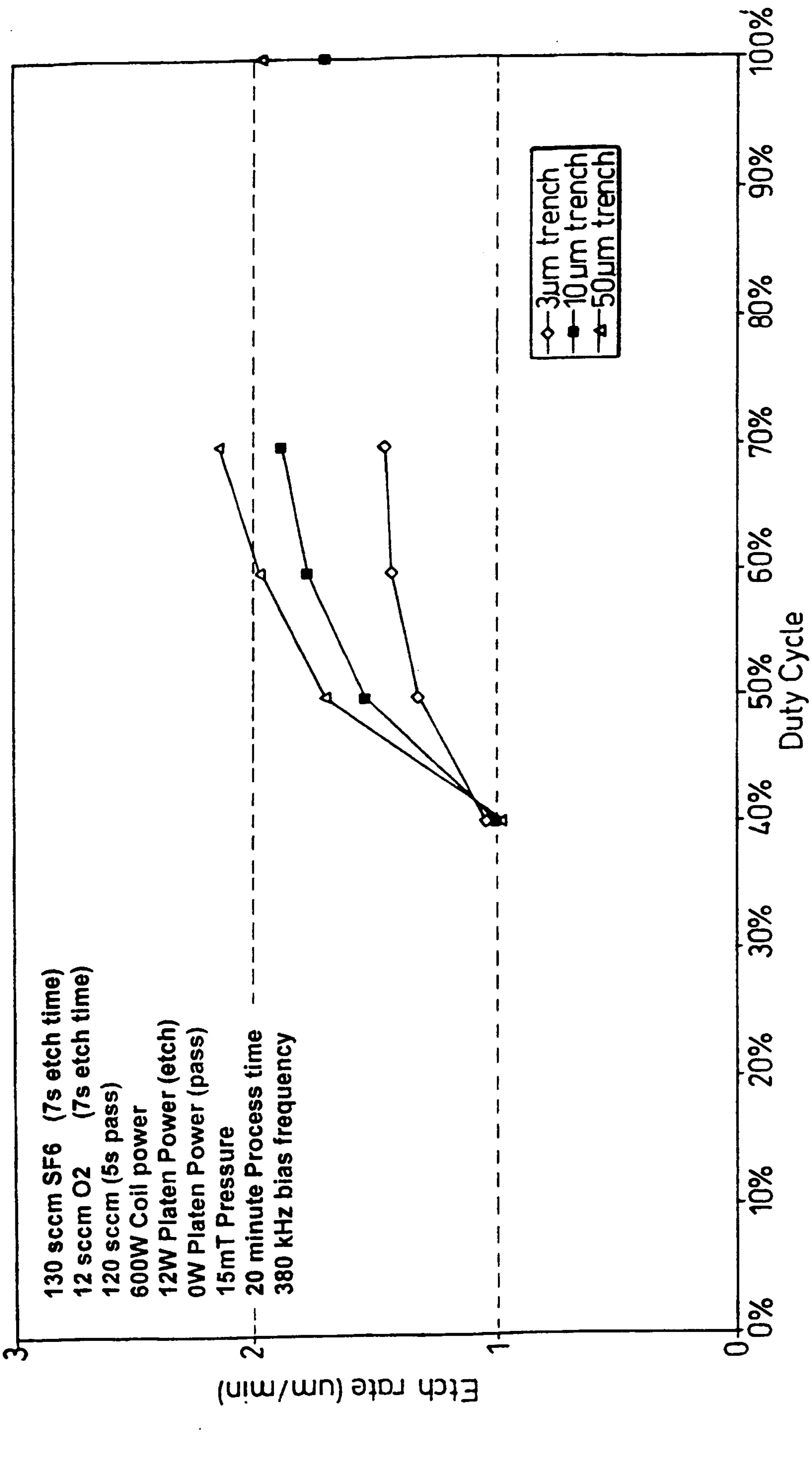


*Fig. 9*

**Variation of etch rate with duty cycle**
**(Bulk, 2.5ms pulse)**

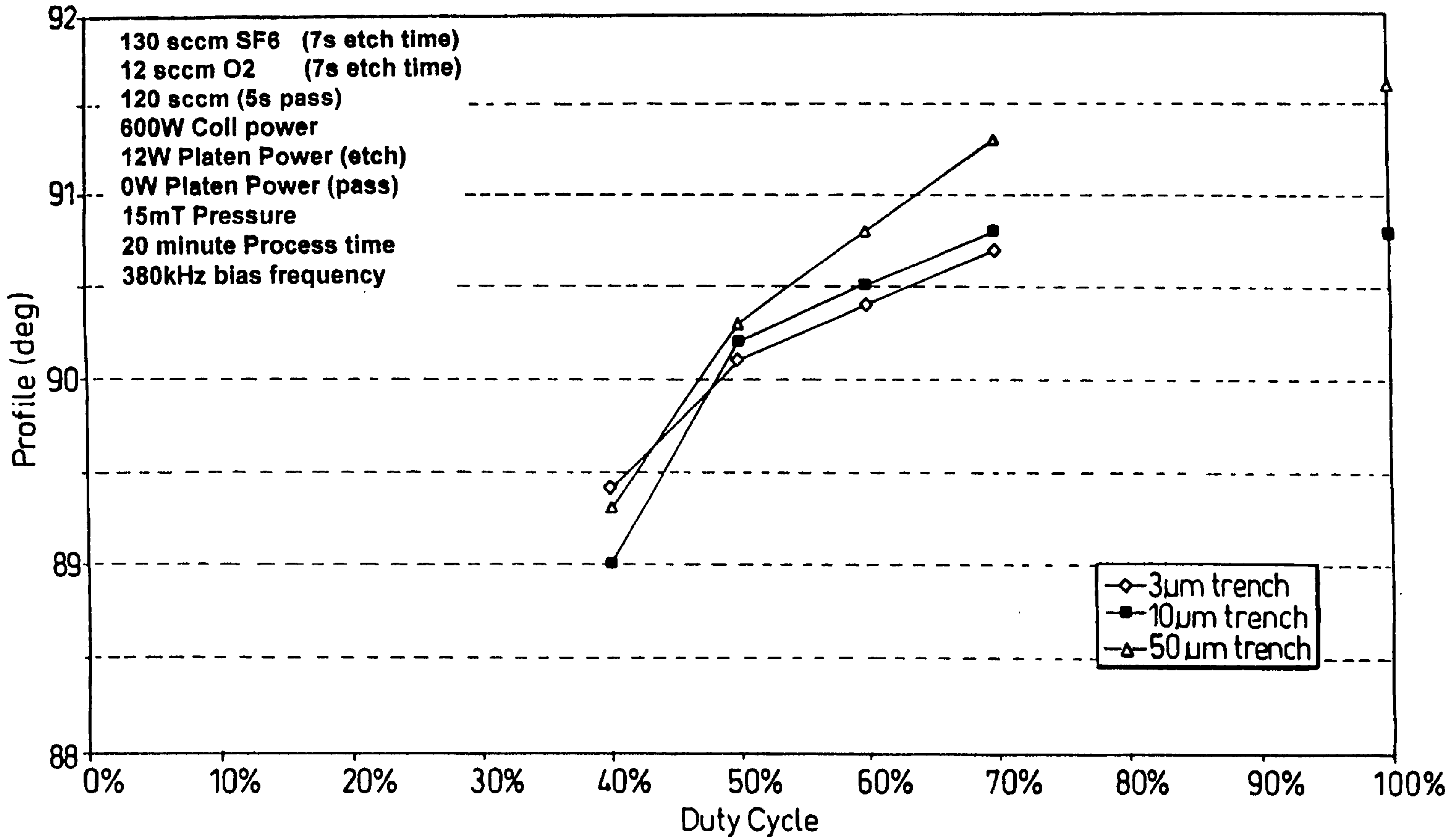


*Fig. 10* **Variation of sidewall angle with duty cycle (Bulk, 2.5ms pulse)**

CIRCUIT TO PULSE RF FED TO PLATEN

*Fig. 11*

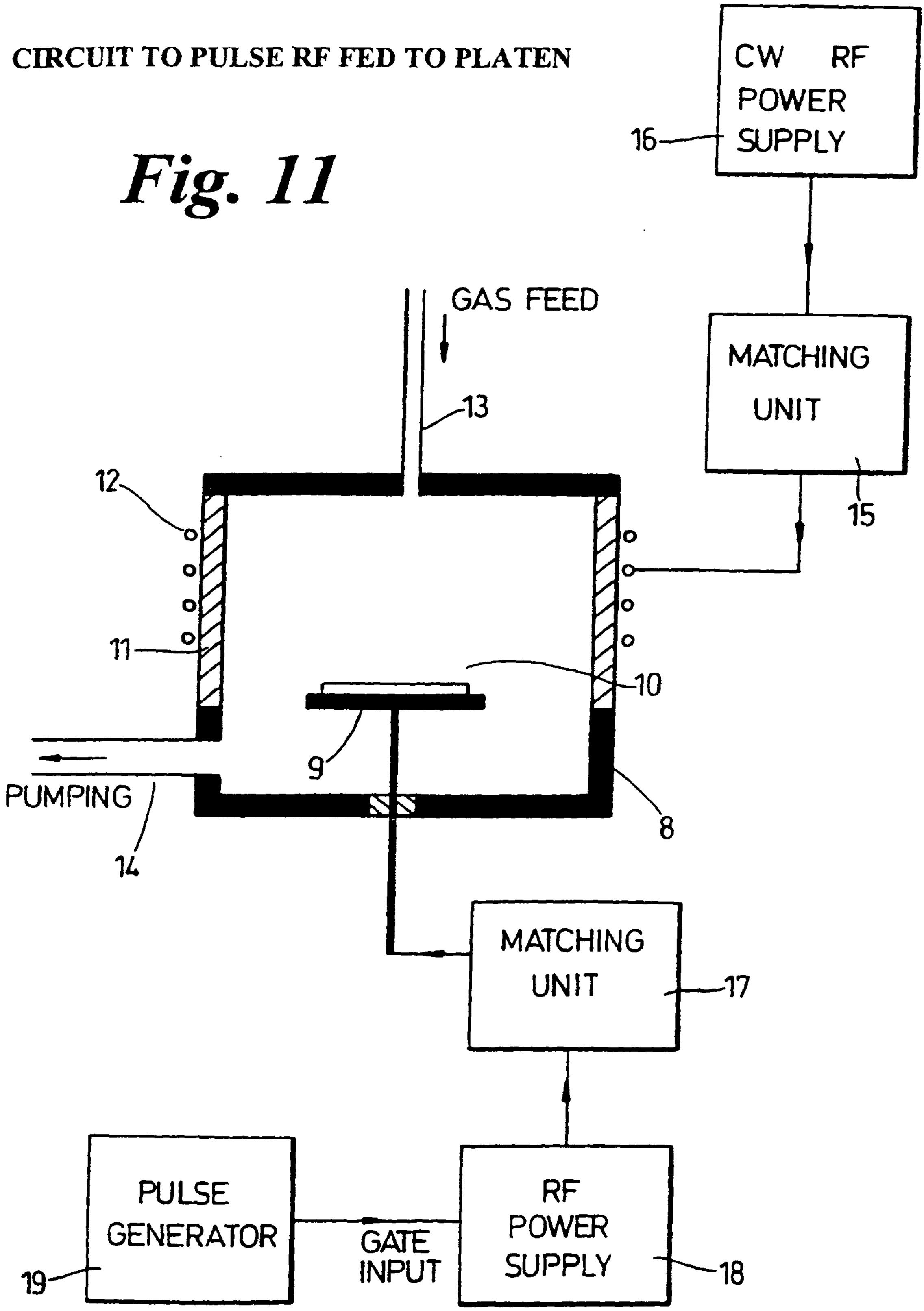

CIRCUIT TO PULSE DC POTENTIAL ON PLATEN

*Fig. 12*

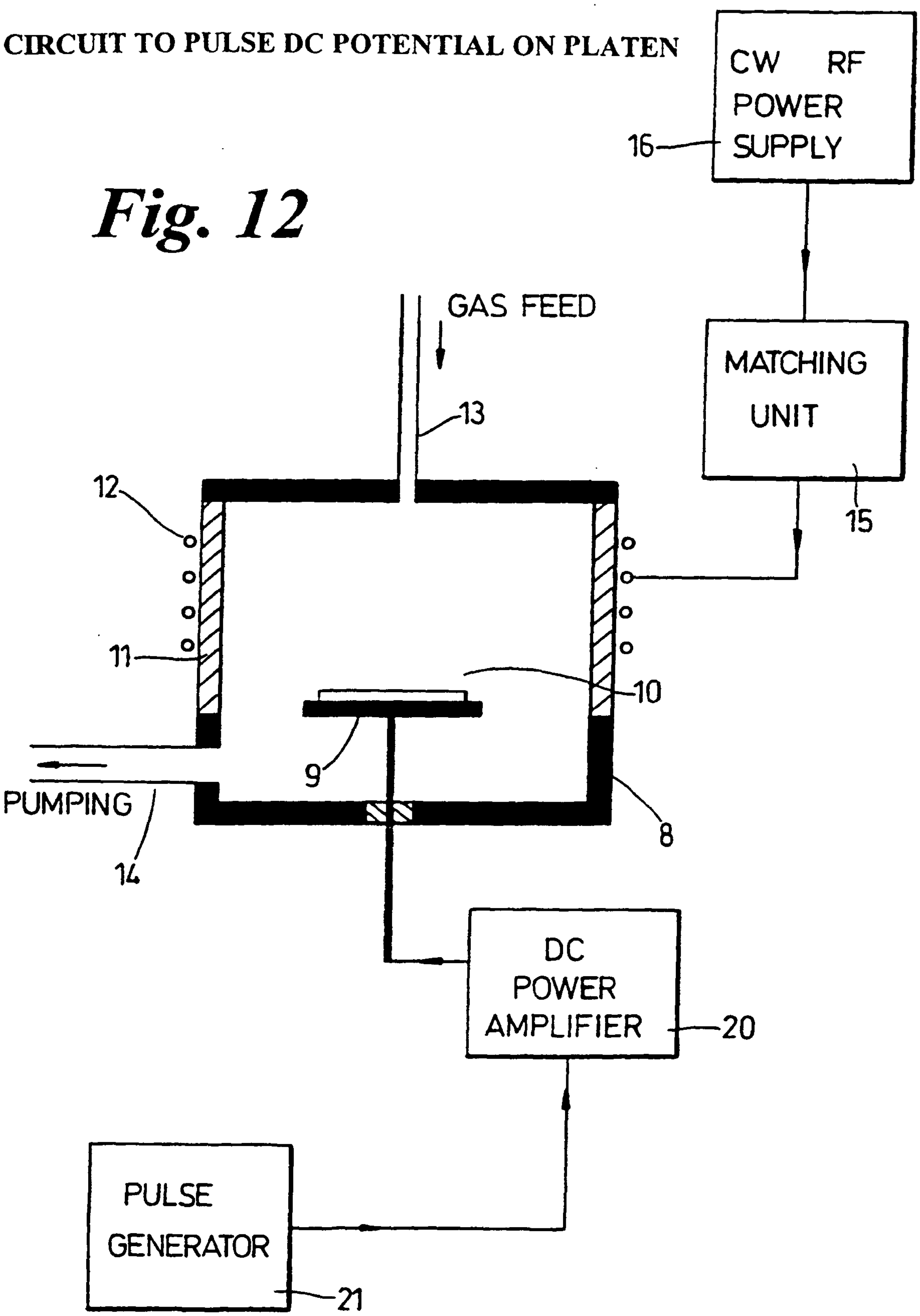

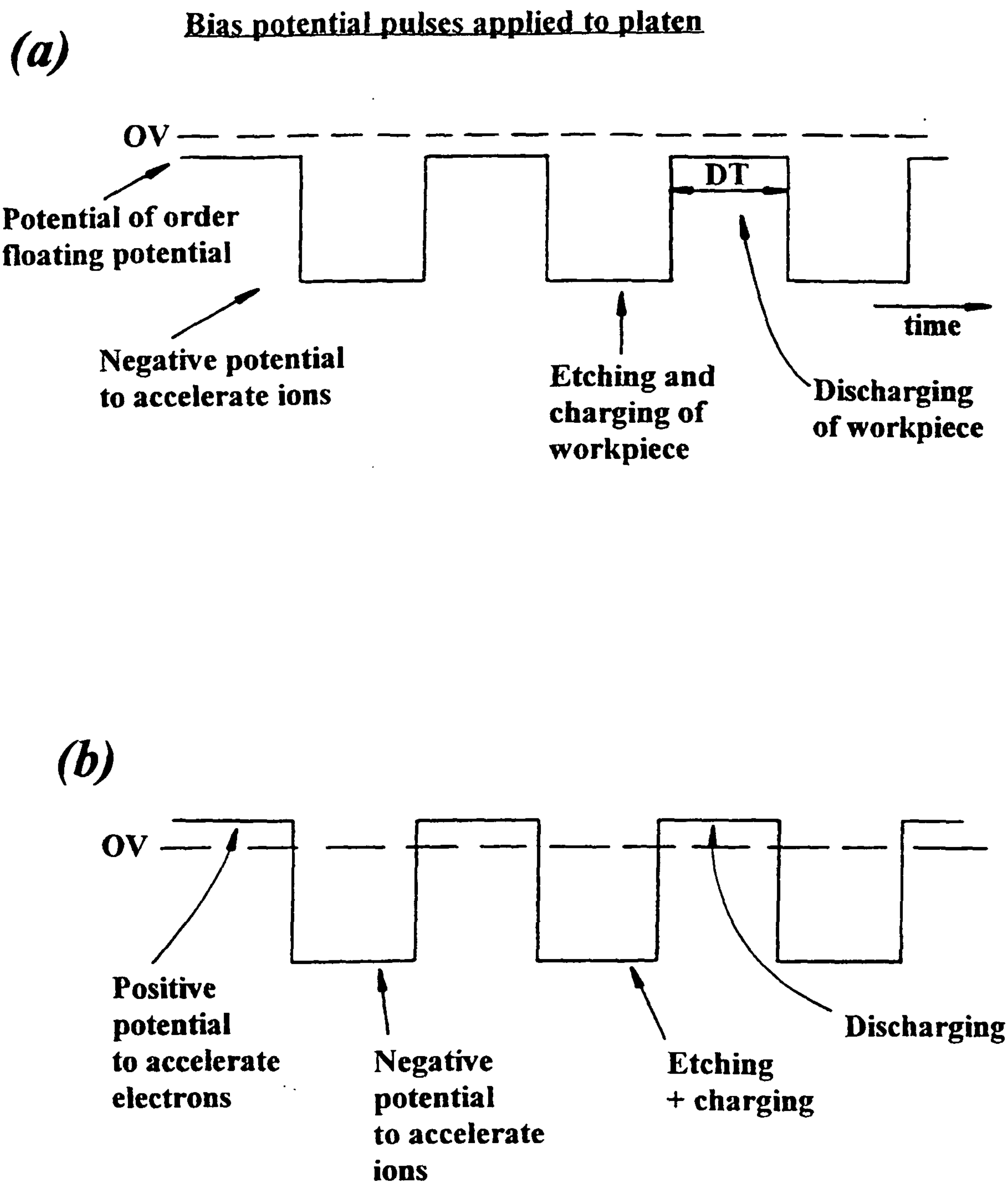
(a)
Bias potential pulses applied to platen
OV
DT
Potential of order
floating potential
time
Negative potential
to accelerate ions
Etching and
charging of
workpiece
Discharging
of workpiece
(b)
OV
Positive
potential
to accelerate
electrons
Negative
potential
to accelerate
ions
Etching
+ charging
Discharging

*Fig. 13*

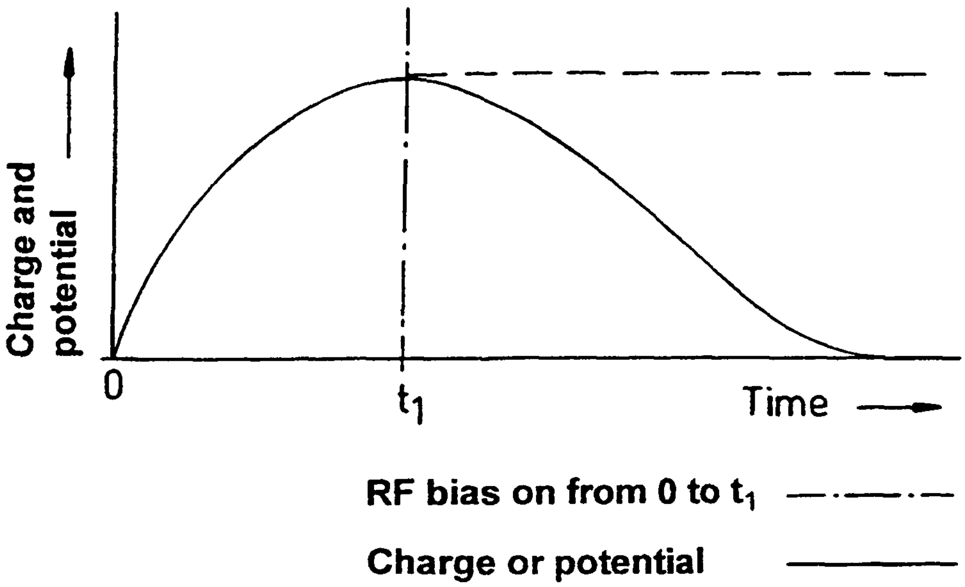
Charge and
potential
0
t1
Time
RF bias on from 0 to t1
Charge or potential

*Fig. 14*

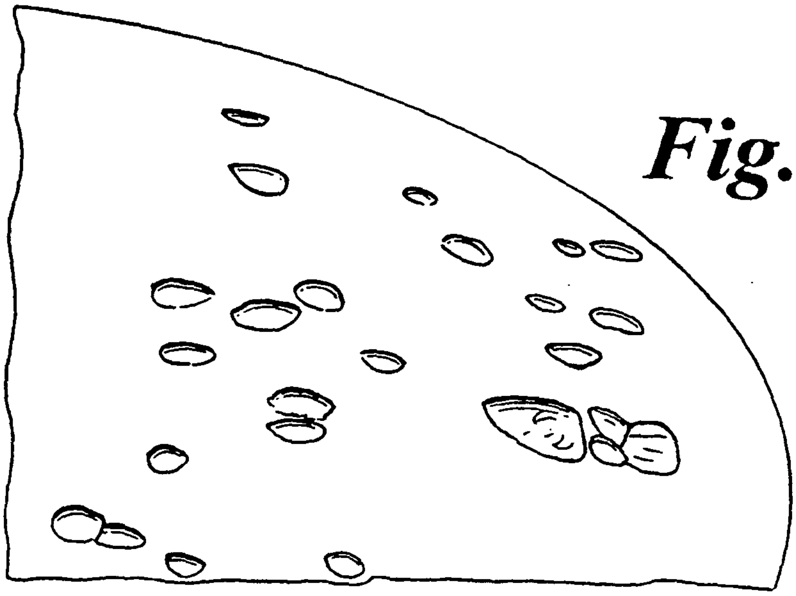

Fig. 15

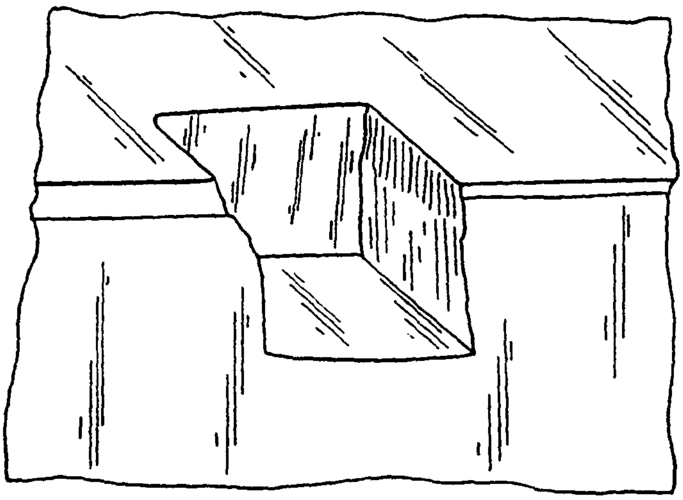

Fig. 16

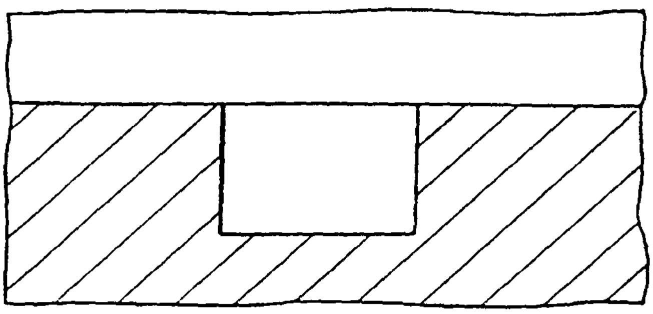

Fig. 17

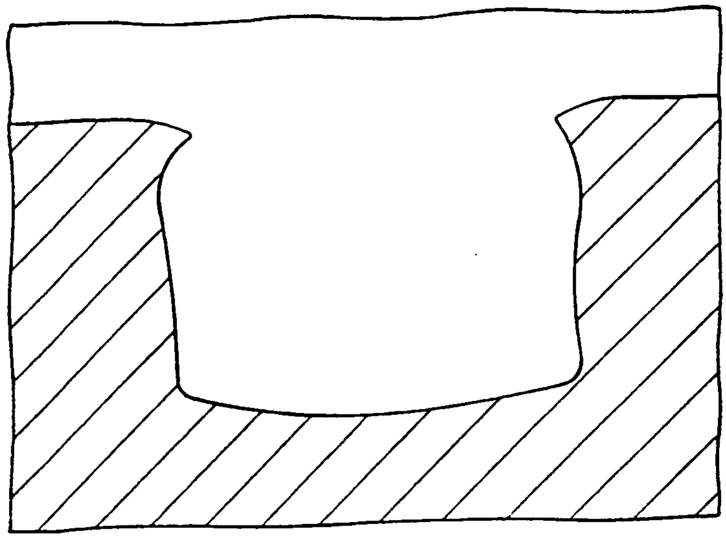

*Fig. 18* Control Run, 13.56Mhz

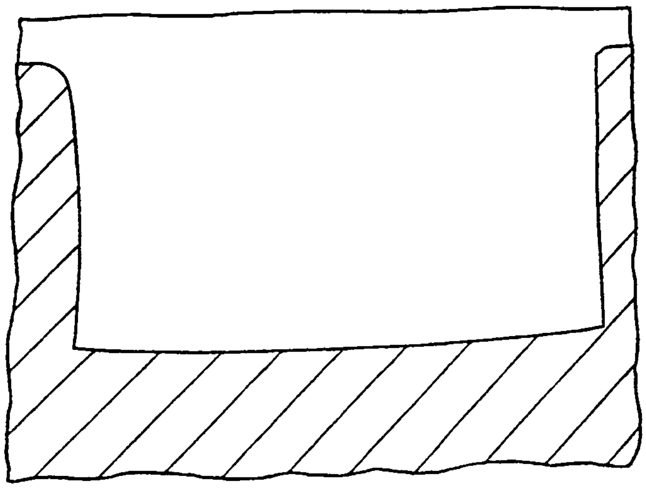

*Fig. 19* LF Platen generator, 380kHz

A

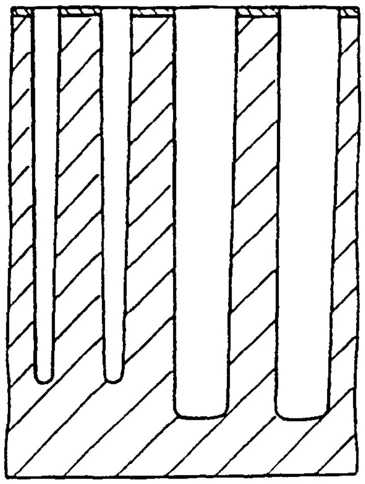

B

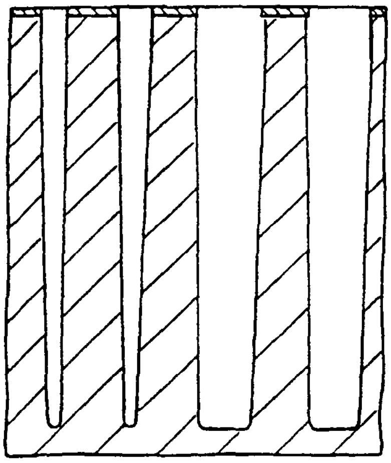

C

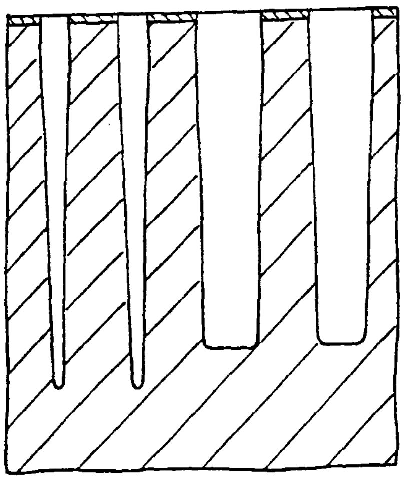

*Fig. 20*

**The SEM micrographs demonstrate control of RIE lag between 2um trench widths and 5um trench widths. The third SEM shows a reverse RIE lag.**

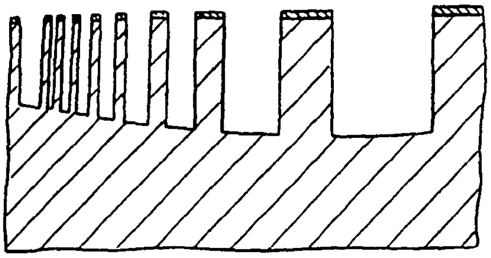

(a) 2.5ms pulse width, 70% duty cycle
RIE lag from 3 um to 50um trench is 69%

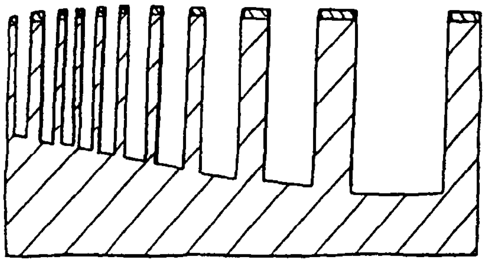

(b) 2.5ms pulse width, 60% duty cycle
RIE lag from 3 um to 50um trench is 73%

Note: Largest trench size shown in Figure is 20um. Trench profile is negatively tapered.

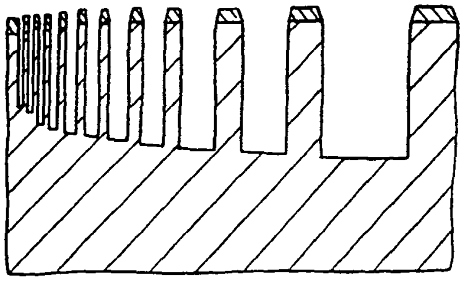

(c) 2.5ms pulse width, 50% duty cycle.
RIE lag from 3um to 50um trench is 78%

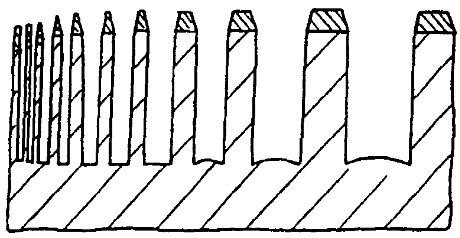

(d) 2.5ms pulse width, 40% duty cycle.
RIE lag from 3um to 50um trench is 106%.

Note: Passivation build up at bases of large trenches can be clearly seen. Also note positively tapered trench profile.

*Fig. 21*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0363982 A
- JP 10074730 A
- EP 0710977 A
- EP 0822582 A
- GB 9827196 A
- WO 9414187 A
- EP 0822584 A

### Non-patent literature cited in the description

- **Toshihisa Nozawa et al.** *Dry Process Symposium, Tokyo,* 1994, vol. I-8, 37ff
- **Morioka et al.** *J. Vac. Sci. Technol. A,* May 1998, vol. 16 (3), 1588-1593
- **Kinoshita et al.** Simulation of Topography Dependent Charging with Pulse Modulated Plasma. *Proc.Sym. On Dry Process,* 1996, vol. 18, I-6, 37-42
- **Maruyama et al.** Reduction in charge build-up with pulse-modulated bias in pulsed ECR plasma. *IEE Proc. Dry Process Sym. Japan,* 1997, vol. I-4, 21-26
- **Kure et al.** Highly Anisotropic Microwave Plasma Etching for High Packing Density Silicon Patterns. *USA IEEE,* 1992, 48-49